# EUROPÄISCHE PATENTSCHRIFT

(11) **EP 2 393 613 B1**
(45) Veröffentlichungstag und Bekanntmachung des Hinweises auf die Patenterteilung: **22.04.2015**
(21) Anmeldenummer: 10703051.2
(22) Anmeldetag: 03.02.2010
(51) Int. Cl.: B05D 1/00, B05D 7/24, C23C 16/40, B05D 3/14, B32B 33/00, B32B 38/16, C23C 16/02

(54) **KUNSTSTOFFSUBSTRAT, UMFASSEND EINE FLEXIBLE, TRANSPARENTE SCHUTZSCHICHT SOWIE VERFAHREN ZUR HERSTELLUNG EINES SOLCHEN KUNSTSTOFFSUBSTRATES**
PLASTIC SUBSTRATE COMPRISING A FLEXIBLE, TRANSPARENT PROTECTIVE COATING AND METHOD FOR PRODUCING SUCH A PLASTIC SUBSTRATE
SUBSTRAT SYNTHÉTIQUE, COMPRENANT UNE COUCHE DE PROTECTION FLEXIBLE ET TRANSPARENTE ET PROCÉDÉ DE FABRICATION D'UN TEL SUBSTRAT SYNTHÉTIQUE

(30) Priorität: 06.02.2009 DE 102009000699
(43) Veröffentlichungstag der Anmeldung: 14.12.2011
(73) Patentinhaber: Fraunhofer-Gesellschaft zur Förderung der angewandten Forschung e.V., 80686 München (DE); Impreglon Beschichtungen GmbH, 86899 Landsberg am Lech (DE); Vereinigung zur Förderung des Instituts für Kunststoffverarbeitung in Industrie und Handwerk An der RWTH Aachen e.V., 52062 Aachen (DE)
(72) Erfinder: SALZ, Dirk, 28195 Bremen (DE); VISSING, Klaus-Dieter, 27321 Thedinghausen (Morsum) (DE); DÖLLE, Christopher, 27749 Delmenhorst (DE); PAULING, Alexander, 41236 Möchengladbach (DE); GRÖNLUND, Oliver, 52072 Aachen (DE)
(74) Vertreter: Eisenführ Speiser
(86) Internationale Anmeldenummer: PCT/EP2010/051324
(87) Internationale Veröffentlichungsnummer: WO 2010/089333

(56) Entgegenhaltungen:
- EP-A1- 0 752 483
- DE-A1- 4 238 279
- DE-A1- 19 901 834
- DE-A1-102006 018 491
- US-A- 5 679 413
- HEGEMANN D ET AL: "Deposition of SiOx films from O2/HMDSO plasmas" SURFACE AND COATINGS TECHNOLOGY, ELSEVIER, AMSTERDAM, NL LNKD- DOI:10.1016/S0257-8972(99)00092-4, Bd. 116-119, 1. September 1999 (1999-09-01), Seiten 1033-1036, XP002531328 ISSN: 0257-8972

## Beschreibung

Die Erfindung betrifft ein Verfahren zum Beschichten der Oberfläche eines Kunststoffsubstrates mit einer Kratzschutzschicht, ein Verfahren zur Herstellung eines Bauteiles mit einer Kratzschutzschicht, ein entsprechendes beschichtetes Kunststoffsubstrat sowie ein entsprechend beschichtetes Bauteil. Sie betrifft ferner die Verwendung einer beschichteten Kunststofffolie in Verfahren zum Laminieren, Kaschieren, Heißprägen, Spritzgießen, Blasformen, Pressen, Hinterspritzen, Hinterprägen, Spritzprägen, Thermoformen oder Strangablegen.

Es besteht ein hoher Bedarf an Kratzschutzschichten um Oberflächen dauerhaft gebrauchsfertig zu machen, d.h. mechanisch und chemisch zu schützen. Naheliegende Einsatzfelder sind transparente Kunststoffe wie PC (Polycarbonat) oder PMMA (Polymethylmetacrylat) oder PET (Polyethylenterphathalat) (ggf. auch lackiert), aber auch nicht transparente Kunststoffe (ggf. eingefärbt), die beispielsweise für Verglasungszwecke, Sensorzwecke, Visiere, Displays, Bedienelemente etc. eingesetzt werden. Weiterer Bedarf ist im Sektor der folienverarbeitenden Industrie erkennbar. Hierzu gehören Hersteller von Handys o.ä., als auch Verarbeiter, die Folien über Laminier-, Kaschier- oder Hinterspritzprozesse verarbeiten. Darüber hinaus sind auch viele Lackierungen, Kunststoffbeschichtungen oder Kunststoffoberflächen nicht sonderlich kratzfest, so dass auch in diesem Bereich eine Notwendigkeit besteht solche Oberflächen zu schützen.

Durch eine geeignete Kratzschutzbeschichtung werden viele Anwendungen, in denen kratzfestes Vollmaterial, oftmals Glas, eingesetzt wird, für andere Materialien, insbesondere Kunststoffe, zugänglich. Die Möglichkeit, Freiheit in der Materialwahl zu erhalten, ist auf vielfältige Weise vorteilhaft für die Gestaltungsmöglichkeiten, zur Gewichtsreduzierung, zur Kostenersparnis etc.

Ein Teil der Produkte, die eine hohe Kratz- bzw. Abrasionsfestigkeit benötigen, ist während der Verarbeitung oder des Gebrauches starken mechanischen Belastungen, auch Verformungen, UV-Strahlung oder auch hohen thermischen Belastungen ausgesetzt. Beispielsweise wird ein Visier beim Einbau in einen Helm deutlich verformt, eine Folie für Folienhinterspritz- oder Kaschierprozesse wird starken Verformungen und hohen Temperaturen ausgesetzt oder eine Automobilverglasung, wie auch Displays für z.B. Handys werden hohen mechanischen Beanspruchungen ausgesetzt. Ein anderer Teil der Produkte wird dagegen erst während des Gebrauchs durch hohe Temperatureinwirkung stark beansprucht. Hierzu gehören beispielsweise Visiere für Feuerwehrleute. Zusätzlich sind die Produkte während der Verarbeitung und vor allem während des Gebrauchs UV-Strahlung ausgesetzt, insbesondere bei Außenanwendungen aber auch Innenanwendungen, wenn eine intensive Beleuchtung mit Kunstlichtquellen vorliegt.

Für solche Produkte ist es wichtig, dass eine Kratzschutzschicht ein komplexes Eigenschaftsprofil aufweist, welches neben der Kratzfestigkeit hohe mechanische Flexibilität, geringe Rissneigung bei Dehnung oder Stauchung, hohe optische Transparenz, exzellente Substrathaftung und hohe thermische Stabilität dauerhaft gewährleistet. Beispielsweise soll eine Folie mit Kratzschutzbeschichtung immer noch die typischen Folieneigenschaften aufweisen, sie soll also wickelbar und flexibel sein.

### Stand der Technik:

Aus dem Stand der Technik sind primär Kratzschutzschichten bekannt, die Quarzglasähnlich (SiO₂-ähnlich) sind. Zu ihrer Herstellung sind verschiedene Vakuumverfahren, wie Sputtern oder PECVD-Verfahren bekannt. Allen Schichten ist gemein, dass sie sich durch eine hohe Härte und Sprödigkeit auszeichnen. Werden derart beschichtete Objekte als ganzes stark verformt, so erleiden diese Kratzschutzbeschichtung sehr schnell eine feine Rissbildung. Hierdurch sind die Schichten für viele Anwendungen ungeeignet, insbesondere für Anwendungen, in denen mechanische Verformungen während der Herstellung oder des Gebrauchs notwendig und unvermeidbar sind.

Weiterhin ist aus der deutschen Patentanmeldung mit dem Aktenzeichen DE 10 2007 040 655.1 eine Funktionsschichtübertragungsanordnung bekannt, bei der die Funktionsschicht temporär auf einem Träger abgeschieden und später, nach der Entfernung des Trägers, auf dem Bauteil verbleibt. Es werden aber nur bisher bekannte plasmapolymere Kratzschutzschichten in dieser Anmeldung offenbart, da der Kern der Anmeldung auf die Schichtübertragung zielt.

Weiterhin sind thermoformbare Kratzschutzlacke bekannt, die mittlere Kratzschutzanforderungen erfüllen können. Hierzu gehören beispielsweise AR65-8, eine einteilige lösungsmittelgestützte Beschichtung der Firma FSI (Film Specialties, Inc., Hillsborough, NJ 08844) oder UV-härtende Systeme, wie sie beispielsweise von der Fa. MacDermid angeboten werden. Diese Systeme werden für das Folienhinterspritzen genutzt. Derartige Kratzschutzschichten weisen den Nachteil auf, dass Härte und Flexibilität gegensätzliche Anforderungen darstellen und so nur ein Kompromiss mit geringen Kratzschutzqualitäten möglich ist.

Darüber hinaus sind witterungsbeständige Folien (DE 09319153) bekannt, die auf empfindliche Kunststoffoberflächen aufkaschiert werden können. Derartige Folien können einen hervorragenden UV-Schutz liefern, als auch gegen andere äußere Einflüsse schützen. Allerdings ist eine solche Folie keine Kratzschutzfolie.

Schließlich ist bekannt, dass Kratzschutzbeschichtungen, welche mittels Plasmapolymerisation hergestellt werden, höchste Ansprüche hinsichtlich der mechanischen Abrasionsfestigkeit (Δ-haze - Wert nahe 1) und der UV-Stabilität liefern. Um die positiven Eigenschaften plasmapolymerer Beschichtungen für Kunststoffprodukte nutzen zu können geht man üblicherweise so vor, dass die zu veredelnden Objekte in die Plasmapolymerisationsanlage gegeben und beschichtet werden. Ein ggf. notwendiger UV-Schutz kann über zuvor aufgebrachte Lacke realisiert werden. Solche Produkte bietet z.B. die Fa. Exatec an. Zu deren Herstellung wird eine Vielzahl von Arbeitsschritten benötigt, die ein solches Vorgehen aufwändig, teuer und fehleranfällig machen.

Die deutsche Patentanmeldung mit dem Aktenzeichen DE 10 2007 000 611.1 beschreibt eine kratzfeste Korrosionsschutzschicht lediglich für Leichtmetalloberflächen, die eine hohe Flexibilität aufweist.

EP 0 752 483 A1 offenbart ein Verfahren zur Beschichtung von Gegenständen aus Metall, Metall-Legierungen, Kunststoffen oder mit entsprechenden Oberflächen mit einer Schutzschicht nach vorheriger Reinigung mittels eines plasmaunterstützten CVD-Verfahrens durch eine elektrische Plasmaanregung bei vermindertem Gasdruck unter Einleitung einer Gasmischung mit reaktionsfähigen, schichtbildenden Gasen und Steuerung des Arbeitsdrucks, wobei zur Bildung einer quarzartigen Schicht als reaktionsfähige Gase neben Sauerstoff der Dampf leicht verdampfbaren siliziumorganischen Verbindung oder ein siliziumhaltiges Gas eingeleitet werden, wobei die reaktionsfähigen Gase in einer solchen Mischung eingeleitet werden, dass der Anteil des reaktiven Sauerstoffs nicht zur quantitativen Umsetzung zu Siliziumdioxid ausreicht, und die Abscheideparameter der elektrischen Gasentladung so gesteuert werden, dass sich eine quarzähnliche Schicht bildet, die neben Silizium und Sauerstoff auch organische, plasmapolymerisierte Komponenten in homogener Verteilung enthält.

US 5,679,413 A beschreibt ein in abrasionsverschleißfest beschichtetes Substratprodukt umfassend ein Substrat und ein abrasionsverschleißfeste Beschichtungsmaterial enthaltend Kohlenstoff, Wasserstoff, Silizium und Sauerstoff. Das abrasionsverschleißfeste Beschichtungsmaterial hat eine Nanoindentationshärte im Bereich von etwa 2 bis etwa 5 GPa, eine Dehnung bis Mikroriss von mehr als etwa 1% und eine Transparenz größer als 85% im sichtbaren Spektrum. Die beschichteten Produkte sind geeignet zur Verwendung in optischen Anwendungen wie Brillengläser oder Fenster für Strichcode-Laserscanner. Bei der Herstellung der Produkte wird das Substrat zunächst chemisch gereinigt, um Verunreinigungen zu entfernen. Im zweiten Schritt wird das Substrat in eine Vakuumkammer eingeführt, und die Kammer wird evakuiert. Im dritten Schritt wird die Substratoberfläche mit energiereichen Ionen und/oder reaktiven Spezies beschossen, um die Entfernung von restlichen Kohlenwasserstoffen und Oberflächenoxiden zu unterstützen und die Oberfläche zu aktivieren. Nachdem die Substratoberfläche geätzt wurde, wird eine schützende, abriebfeste Beschichtung durch Plasma oder lonenstrahlabscheidung abgeschieden. Sobald die gewählte Dicke der Beschichtung erreicht worden ist, wird die Abscheidung beendet, der Druck in der Vakuumkammer wird auf Atmosphärendruck erhöht, und die beschichteten Substrate mit verbesserter Abriebfestigkeit werden aus der Vakuumkammer entfernt.

DE 199 01 834 A1 offenbart ein Verfahren zum Beschichten von Substraten aus Kunststoff mit einem transparenten, kratz- und abriebunempfindlichen und gegen Witterungseinflüsse beständigen Schichtpaket mit einem in einer Vakuumkammer in einigem Abstand yom Substrat brennenden Plasma, wobei in einem ersten Verfahrensschritt eine Substratreinigung mit einem oxidierenden Gas, danach in einem zweiten Verfahrensschritt eine Vernetzung mit einem inerten Gas vorgenommen wird und in einem dritten Verfahrensschritt für die Erzeugung einer ersten Sperrschicht ein oxidierendes Gas und eine siliziumorganische Verbindung, in einem vierten Verfahrensschritt zum Aufbringen einer Unterschicht ein oxidierendes Gas, eine siliziumorganische Verbindung und eine UV-absorbierende Verbindung, in einem fünften Verfahrensschritt zum Aufbringen einer Kratzschicht ein oxidierendes Gas und eine siliziumorganische Verbindung und in einem sechsten Verfahrensschritt zum Aufbringen einer Gleitschicht ein inertes Gas und eine siliziumorganische Verbindung benutzt werden.

In der Veröffentlichung "Deposition of SiOx films from O2/HMDSO plasmas" von D. Hegemann et al. (Surface and Coatings Technology 116-119 (1999) 1033-1036) wird beschrieben, wie beim Beschichten von Polymeren durch Variation des Verhältnisses O₂/HMDSO in einem Radiofrequenz-Plasma die Filmeigenschaften und Abscheidungsgeschwindigkeiten optimiert werden können.

Im Stand der Technik wird somit keine Lösung angeboten, die den geforderten Eigenschaftsverbund aufweist.

Angesichts der Nachteile der im Stand der Technik als Kratzschutzschichten für Kunststoffe eingesetzten Schichten war es Aufgabe der vorliegenden Erfindung ein Verfahren zum Beschichten einer Oberfläche eines Kunststoffsubstrates anzugeben, wobei eine Schicht abgeschieden wird, die hinsichtlich ihrer Eigenschaften speziellen Anforderungen von Kunststoffprodukten und der dazugehörigen Kunststoffverarbeitung entspricht, aber auch über einen ausreichenden Kratzschutz verfügt. Bevorzugt sollten die im erfindungsgemäßen Verfahren hergestellten Beschichtungen flexibel, geringe Rissneigung bei Dehnung oder Stauchung, transparent und/oder durch ein schnelles, verfahrenssicheres und/oder preisgünstiges Verfahren herstellbar sein, wobei bevorzugt eine einfache und schnelle Applikation der Beschichtung ggf. mit integriertem UV-Schutz ermöglicht sein sollte. Des Weiteren soll das Verfahren bevorzugt auch kontinuierlich durchgeführt werden können.

Diese Aufgabe wird gelöst durch ein Verfahren zum Beschichten der Oberfläche eines Kunststoffsubstrates, mit folgenden Schritten:
A. Bereitstellen des Kunststoffsubstrates und gegebenenfalls Säubern der zu beschichtenden Substratoberfläche,
B. Beschichten der gegebenenfalls in Schritt A gesäuberten Substratoberfläche in einem Plasmapolymerisationsreaktor mittels Plasmapolymerisation, wobei in Schritt B
   - als Precursor(en) für das Plasma eine oder mehrere siliciumorganische sowie (a) keine weiteren oder (b) weitere Verbindungen eingesetzt werden und
      das Kunststoffsubstrat im Hochfrequenzplasmapolymerisationsreaktor so angeordnet wird, dass es sich zwischen der Zone, in der das Plasma gebildet wird, und der Kathode befindet,
      eine Regelung erfolgt, so dass der Self-Bias im Bereich von 100 bis 300 V liegt,
      wobei das Verfahren so geführt wird, dass die durch das Verfahren hergestellte Beschichtung
   - eine Rissdehnung (Dehnung bis Mikroriss) von ≥ 2,5 %
   - einen nach ASTM D 1925 bestimmten Gelbindex (Yellow Index) von ≤ 3, vorzugsweise ≤ 2,5 und
   - eine mittels Nanoindentation zu messende Härte im Bereich von 2,5 bis 6 GPa, vorzugsweise 3,1 bis 6 GPa
aufweist. Falls erwünscht kann zwischen Schritt A und B noch eine Haftvermittlerbeschichtung eingefüht werden (siehe Anwendungsbeispiel 2 in den Schritten 2 + 3).

Die Rissdehnung (Dehnung bis Mikroriss) wird nach dem im Beispiel 3 beschriebenen Verfahren bestimmt.

Zur Verfahrensführung erhält der Fachmann weiter unten eine Vielzahl von Hinweisen.

Unter Hochfrequenzplasmen sollen hier alle Plasmen außer Gleichspannungsplasmen verstanden werden, insbesondere solche im MHz Bereich.

Die Anordnung des Kunststoffsubstrates während des Schrittes B, "*so dass* es *sich zwischen der Zone, in der das Plasma gebildet wird, und der Kathode befindet",* bedeutet: Es liegt auf der Elektrode oder nah an der Elektrode. Nah heißt hier im Bereich des RF-sheath (Dunkelraum) (typisch 2-5 mm beabstandet). Bahnware kann analog in kontinuierlichen Verfahren nah an der Elektrode vorbeigeführt werden. Oft ist es bevorzugt, dass in Schritt B kein direkter Kontakt zwischen Substrat und Elektrode (Kathode) besteht.

Nähere Erläuterungen zu Plasmen und dem RF-sheath finden sich in: "Principles of plasma discharges and materials processing"; Michael A. Lieberman, Allan J. Lichtenberg, John Wiley & Sons, Inc.; 4. Ausgabe S. 340 ff.

Ein Kunststoffsubstrat im Sinne dieser Anmeldung ist ein fester, organisch-chemischer Werkstoff, der durch chemische Veränderung von Naturstoffen oder aus anorganischen und organischen Rohstoffen künstlich hergestellt wird. Es handelt sich dabei insbesondere um synthetische Polymere, die durch Polymerisation, Polykondensation oder Polyaddition aufgebaut werden können.

Bevorzugte Kunststoffsubstrate im Sinne dieser Anmeldung sind Folien. Unter einer Folie ist bevorzugt folgendes zu verstehen: Ein flächiges Produkt mit einer Dicke von wenigen µm bis zu ca. 1 - 2 mm. Unabhängig von der Foliendicke ist ein wesentliches Merkmal für eine Folie, dass derartige Produkte prinzipiell in Rolle zu Rolle - Verfahren bearbeitbar sind; dies ist bei Tafelware nicht mehr der Fall. Bevorzugt werden als Kunststoffsubstrate dabei Folien verwendet, die sich gut für Kaschier- oder Laminierprozesse oder auch für Verfahren der Folienhinterspritzung eignen.

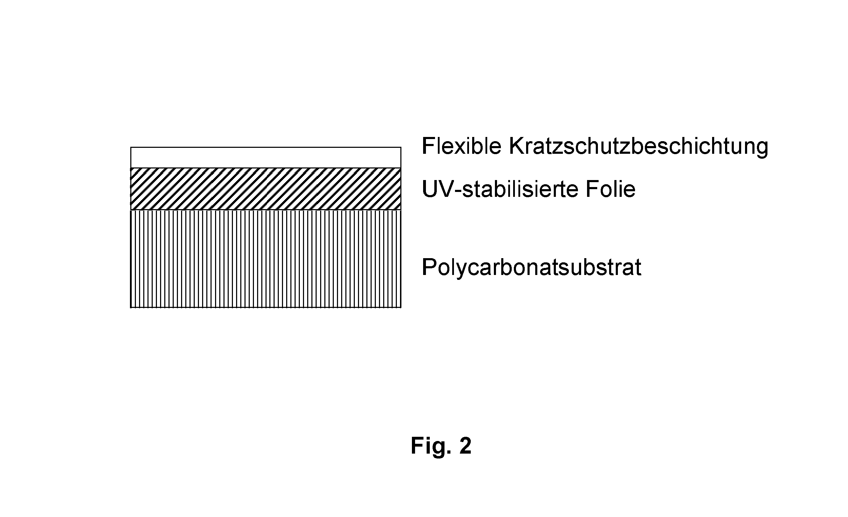

Darüber hinaus können derartige Folien auch so ausgewählt werden, dass sie witterungsstabil, insbesondere UV-stabil ausgerüstet sind. Im erfindungsgemäßen Verfahren beschichtete Folien können anschließend auf ein zu beschichtendes Bauteil übertragen werden. Die Übertragung kann z.B. im Spritzguß-, Kaschier- oder Laminierprozess erfolgen. So lässt sich beispielsweise eine Polycarbonatscheibe entsprechend Fig. 2 herstellen, die noch thermisch umformbar ist. Das gesamte Produkt ist anschließend deutlich besser kratzfest und vor UV-Strahlung geschützt.

Die Übertragung der beschichteten Folie erfolgt in der Weise, dass die durch das erfindungsgemäße Verfahren hergestellte Kratzschutzbeschichtung nach außen zeigt und die Folie sich zwischen der Beschichtung und dem zu beschichteten Bauteil befindet.

Die Beschichtung auf dem Kunststoffsubstrat, die im erfindungsgemäßen Verfahren hergestellt wird, ist eine hochflexible, plasmapolymere Beschichtung mit guten Kratz- und Abrasionsschutzeigenschaften. Sie wird nachfolgend auch als Kratzschutzbeschichtung oder - schicht bezeichnet. Insbesondere zeichnet sie sich durch eine bisher unbekannte vorteilhafte Kombination von Eigenschaften aus, die bislang als nicht miteinander vereinbar betrachtet wurden, nämlich gute Kratzfestigkeit und Flexibilität (Rissdehnung vorzugsweise größer oder gleich 2,5 %, bevorzugt ≥ 2,75 %, weiter bevorzugt ≥ 3%, insbesondere größer oder gleich 3,1 %), der bevorzugte Maximalwert beträgt 6%) bei hoher Transmission im sichtbaren Bereich und UV-Beständigkeit. Bevorzugte Mindestwerte der Kratzschutzschicht für die mittels Nanoindentation zu messene Härte sind dabei 2,5 GPa, bevorzugt 2,75 GPa, weiter bevorzugt 3 GPa und besonders bevorzugt 3,1 GPa. Zudem können durch das erfindungsgemäße Verfahren auch eine überraschend gute Substrathaftung, und/oder eine hohe Schichtdickenhomogenität erreicht werden.

Bevorzugte erfindungsgemäße abzuscheidende Beschichtungen weisen einen durch Messung mittels XPS bestimmbaren Anteil von Kohlenstoff von 3 bis 28 %, vorzugsweise 5 bis 28 Atom-%, weiter vorzugsweise 7 bis 28 Atom-%, bezogen auf die Gesamtzahl der in der Beschichtung enthaltenen Kohlenstoff-, Silicium- und Sauerstoffatome auf, wobei gegebenenfalls die Obergrenze für den C-Anteil bevorzugt 20 Atom-% und weiter bevorzugt 18 Atom-% beträgt.

Die EP 0 748 259 offenbart auch Kratzschutzschichten, die aber keine entsprechende Eigenschaftskombination, insbesondere keine so hohe Rissdehnung zeigen. Auch sind die erfindungsgemäßen Parameterkombinationen hinsichtlich Gelbindexes und der Nanoindentationshärte nicht offenbart.

Beschichtungen mit einem Gelbindex von 2,5 oder darunter weisen in der Regel keine für das menschliche Auge wahrnehmbare Gelbfärbung auf. Der Gelbindex wird wesentlich von dem Anteil an Si-H-Bindungen in der mit dem erfindungsgemäßen Verfahren hergestellten Beschichtung bestimmt, der wie weiter unten ausgeführt für das Erzielen von günstigen Bereichen von Härte und Elastizität und damit für das Erreichen der vorteilhaften Eigenschaftskombination entscheidend ist.

Eine weitere wichtige Kenngröße der plasmapolymeren Beschichtung ist der Kohlenstoffanteil in der mit dem erfindungsgemäßen Verfahren hergestellten Beschichtung, der durch den Anteil an organischen Gruppen beeinflusst wird. Er ist wichtig für die Härte und Elastizität der Beschichtung, die ebenfalls für das Erreichen der vorteilhaften Eigenschaftskombination erwünscht ist. Durch eine hohe Elastizität der Beschichtung kann diese z.B. zusammen mit dem beschichteten Substrat gedehnt werden, ohne dass es zu einer Rissbildung kommt. Bei ausreichender Elastizität der plasmapolymeren Beschichtung kann das Substrat sogar plastisch verformt werden, ohne dass die Beschichtung geschädigt wird. Hierdurch werden Umformprozesse des beschichteten Materials in gewissem Rahmen möglich, so dass der Einsatz in Kaschier-, Laminierverfahren ebenso möglich wird, als auch in Prozessen des Hinterspritzens.

Bei den im erfindungsgemäßen Verfahren herstellbaren Beschichtungen sind im Vergleich zu den nasschemischen Auftragsverfahren, insbesondere Lackierungen, die Kratzfestigkeit, die Rissdehnung und die Dehnbarkeit verbessert (siehe unten). Die Kratzfestigkeit der Schichten ist in vielen Fällen vergleichbar mit der von Glasoberflächen. Durch den Einsatz des erfindungsgemäßen (trockenchemischen) Verfahrens ist es möglich geworden, ggf. gänzlich auf das Lackieren zu verzichten. Dies ist vorteilhaft, da das Lackieren immer hohe Anforderungen an die Umgebungsbedingungen stellt, insbesondere bei Substraten wie Polycarbonat muss Staub vermieden werden. Zudem ermöglicht das erfindungsgemäße Verfahren eine Oberflächenbeschichtung mit sehr hoher Schichtdickenhomogenität und somit auch mit hoher optischer Güte.

Erstaunlicherweise hat sich herausgestellt, dass plasmapolymere Schichten, wie sie in DE 102007000611.1 beschrieben werden, auch für die Beschichtung von dünnen, flexiblen Kunststofffolien benutzt werden können. Sie sind hoch transparent und flexibel. Beispielsweise lassen sich einseitig beschichtete Folien problemlos in beide Richtungen aufwickeln, so dass sie in dem einen Fall auf Zug und im anderen Fall auf Druck belastet werden. Weiter erstaunlich ist, dass sie Dehnungen von größer/gleich 2,5 % überstehen. Dieser Wert wird weiter verbessert, wenn die Substratfolie während der Weiterverarbeitung z.B. durch Kaschieren oder Hinterspritzen erwärmt wird.

Siliziumorganische Verbindungen lassen sich über die Nachbarschaft des vierwertigen Siliziums beschreiben. Man spricht von primären, sekundären, tertiären und quartären Systemen. Technisch weit verbreitet sind sekundäre Systeme in Form von PDMS und quartäre Systeme in Form von SiO₂.

In den letzten Jahren erfuhren auch tertiäre Systeme des Typs SiO_{1,5} R mit R = CH₃ bzw. H (Polymethylsilsesquioxane) eine gewisse Beachtung. Anwendungen finden diese Materialien als Kratzschutzsysteme.

Für plasmapolymere Dünnschichtsysteme sind Stoffe von Interesse, die eine Mischung von tertiären und quartären Systemen darstellen, da sie eine Mischung der flexiblen Eigenschaften der tertiären Systeme mit den harten, besonders kratzfesten Eigenschaften der quartären Systeme ermöglichen. Solche Stoffe lassen sich mit Hilfe von Plasmaprozessen herstellen. Bevorzugt umfasst die plasmapolymere Kratzschutzbeschichtung durch Messung mittels XPS bestimmbare Anteile von 5 bis 40 Atom-%, bevorzugt 20 bis 32 Atom-% Silicium und/oder 30 bis 70 Atom-%, bevorzugt 40 bis 64 Atom-% Sauerstoff, bezogen auf die Gesamtzahl der in der Beschichtung enthaltenen Kohlenstoff-, Silicium- und Sauerstoffatome.

Bevorzugte Verhältnisse der Elemente zueinander sind wie folgt:
Si : O 1 : 1,545 bis 1 : 1,95
   und/oder
Si : C 1 : 1,2 bis 1 : 0,091.

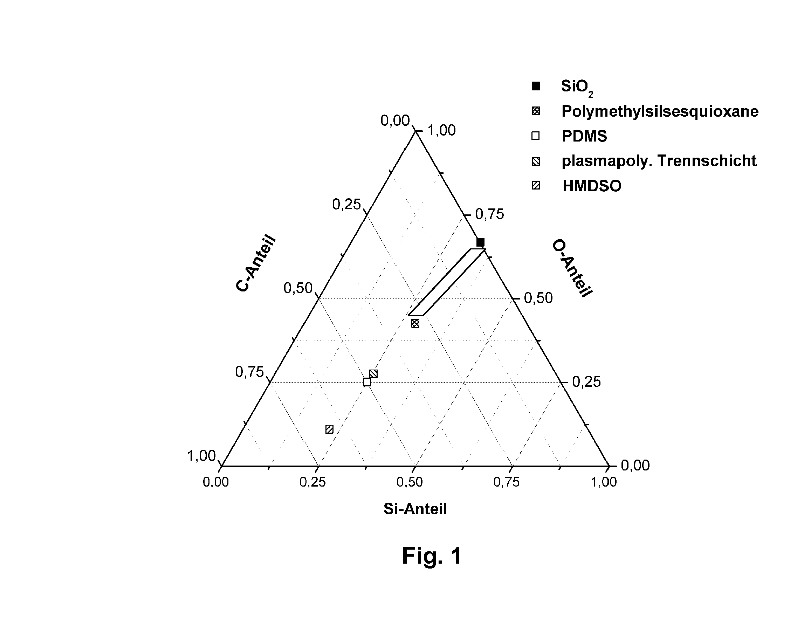

Das besonders bevorzugt angestrebte Elementeverhältnis beträgt Si O_{1,545}(CHₓ)_{0,91} bis Si O_{1,95}(CHₓ)_{0,091} mit x = 2 bis 3 (Fig. 1). In Fig. 1 ist der besonders bevorzugte Bereich der Zusammensetzung der im erfindungsgemäßen Verfahren zu erzeugenden Schichten bezogen auf den C-, Si- und O-Anteil dargestellt. Es sind darüber hinaus in der Fig. 1 Bereiche für weitere Schichtsysteme abgebildet.

Bevorzugt werden SiH-Verbindungen (weitgehend) vermieden, um eine gute optische Transparenz zu ermöglichen und sollen daher bevorzugt mittels IR-Spektroskopie nahezu nicht nachweisbar sein

Die Flexibilität der derart dargestellten Kratzfestbeschichtung wird auf festen Substraten mit Hilfe in Beispiel 3 beschriebenen Testes nachgewiesen. Kratzfest beschichtete Folien sollen bevorzugt ohne Rissbildung mit engen Krümmungsradien gewickelt werden können. Dabei sollte es unerheblich sein, ob die Beschichtung auf Zug oder Druck belastet wird. Typische Wickelradien für derartige Schichten sind für dünne Folien (Dicke 0,01 bis 0,5 mm, z.B. 0,12 mm) im Bereich von 1 - 3 mm, für dickere Materialien (Dicke > 0,5 bis 3 mm, z.B. 1,5 mm) im Bereich von 10 - 30 mm. Diese Voraussetzungen werden von dem erfindungsgemäß abgeschiedenen Schichten regelmäßig erfüllt.

Die plasmapolymere Kratzschutzbeschichtung im Sinne der Erfindung zeichnet sich bevorzugt durch folgende Eigenschaften aus:

**Tabelle: Schichteigenschaften**

| | |
|---|---|
| Härte | 2,5 - 6 GPa |
| Bleistifthärte | ≥ 4 H |
| E-Modul | 12 - 50 GPa, bevorzugt 15 - 30 GPa |
| Transparenz | > 80 % im gesamten sichtbaren Bereich |
| Gelbindex | < 3 %, bevorzugt < 2,5 % |
| Abrasionsfestigkeit | ΔHaze<3%, Taber-Test nach DIN52347, Messung des Streulichts (Haze) nach ISO 3537 |
| Haftfestigkeit | 0 im Gitterschnitttest |
| Dehnbarkeit (Rissdehnung) | ≥ 2,5 % |

Bevorzugt für das erfindungsgemäße Verfahren einzusetzende Kunststoffsubstrate sind im Bereich des sichtbaren Lichtes teiltransparent oder transparent. Da die im erfindungsgemäßen Verfahren zu erzeugende plasmapolymere Kratzschutzschicht ebenfalls transparent ausgestaltet werden kann, lässt sich so eine vorteilhafte Kombination von Kunststoffsubstrat und Kratzschutzschicht erzielen.

Bevorzugt ist das Kunststoffsubstrat eine Folie und/oder ein Thermoplast oder ein Elastomer oder ein thermoplastisches Elastomer. Bevorzugte Materialien für das erfindungsgemäße Verfahren einzusetzende Kunststoffsubstrate, insbesondere als Folie, sind z.B. thermoplastische Folien aus PP (Polypropylen), PE (Polyethylen), PC, PMMA, PET, TPU (thermoplastisches Polyurethan), PVC (Polyvinylchlorid), POM (Polyoxymethylen); TPE (thermoplastisches Polyethylen) und PA (Polyamid).

Für eine Reihe von Anwendungen ist es bevorzugt, dass die im erfindungsgemäßen Verfahren eingesetzte Folie als Kunststoffsubstrat auf der zu beschichtenden Seite oder auch auf der dieser Seite gegenüberliegenden Seite bedruckt oder anders grafisch gestaltet ist. Somit lassen sich im erfindungsgemäßen Verfahren Verfahrensprodukte erzeugen, die bestimmte, gewünschte optische Effekte bewirken können.

Bevorzugt wird das erfindungsgemäße Verfahren für Folien als Bahnbehandlung vorgenommen. Damit ist eine kontinuierliche Beschichtung einer durchlaufenden Folie als Kunststoffsubstrat gemeint.

Durch Variation von Verfahrensparametern lassen sich die Schichteigenschaften in weiten Grenzen wie im Folgenden beschrieben einstellen.

Allgemein wird die Kratzfestigkeit der Schicht durch die geeignete Auswahl von Schichtdicke und -zusammensetzung bestimmt.

Eine Erhöhung des Self-Bias im Plasmapolymerisationsprozess erhöht hierbei die Härte der Schicht und ihre optische Absorption im sichtbaren Bereich (und damit den Gelbindex).

Durch Einstellung der Härte und Dicke der durch das erfindungsgemäße Verfahren herstellbaren Beschichtungen ist es dem Fachmann möglich, hinsichtlich der Kratzfestigkeit der Beschichtung ein Optimum zu erzielen: Ist die Härte zu gering, so ist die abgeschiedene plasmapolymere Schicht nicht genügend kratzfest. Bei zu großer Härte nimmt die Kratzfestigkeit jedoch ebenfalls ab, da die Schicht dann zu spröde wird. Dies kann man beispielsweise bei der mikroskopischen Beurteilung des Fehlerbildes erkennen.

Bevorzugt ist ein erfindungsgemäßes Verfahren, das so geführt wird, dass die durch das Verfahren hergestellte Beschichtung eine Bleistifthärte von 4H oder höher aufweist, bestimmt nach ASTM D 3362. Die Messung der Härte mittels Nanoindentation ist im Beispiel 2 erläutert.

Bei der Einstellung des Self-Bias ist auch die Zusammensetzung des Gasgemisches zu berücksichtigen, aus dem das Plasma erzeugt wird. So ist etwa bei einer hohen Molekülmasse eines Precursors im Allgemeinen ein niedrigerer Self-Bias zu wählen als bei einer geringen Molekülmasse. Je leichter sich ein Precursor ionisieren lässt, desto geringer muss die Plasmaleistung sein, um einen bestimmten Self-Bias zu erreichen. Bei einer hohen elektrischen Leitfähigkeit des Plasmas wird eine geringe Plasmaleistung benötigt, um einen vorgegebenen Self-Bias zu erzielen.

Der Self-Bias kann z.B. bei gleichbleibender Plasmaleistung verringert werden, indem die Plasmaanregungsfrequenz erhöht wird. Er kann aber alternativ und/oder bevorzugt durch Anlegen einer zusätzlichen Gleichspannung an die Elektrode eingestellt bzw. beeinflust werden, so dass er unabhängig von den anderen Verfahrensparametern eingestellt werden kann.

Eine Erhöhung des Self-Bias bewirkt auch eine Verbesserung der Schichtdickenhomogenität. So konnte in eigenen Versuchen etwa festgestellt werden, dass sich auf einem runden Substrat mit einem Durchmesser von 10 cm die maximale Schichtdicke von der minimalen Schichtdicke bei 100 V Self-Bias um den Faktor 1,1 unterscheiden kann, während dieser Faktor bei 200 V Self-Bias 1,005 betragen kann.

Im erfindungsgemäßen Verfahren wird in Schritt B das Kunststoffsubstrat im Plasmapolymerisationsreaktor so angeordnet, dass es sich zwischen der Zone, in der das Plasma gebildet wird, und der Kathode, vorzugsweise in unmittelbarer Nähe der Kathode, so dass durch den Self-BIAS Ionen stärker auf das Substrat beschleunigt werden können, befindet. Ist das isolierende Kunststoffsubstrat sehr dünn, beispielsweise eine Folie sind besonders günstige Bedingungen gegeben. Hierdurch wird das Erzielen einer hohen Abscheiderate der positiv geladenen Ionen des Plasmas, die zur negativ geladenen Kathode hingezogen werden, erleichtert. Wenn das Substrat oberhalb der Kathode eine dünne Folie ist, wird die Wucht, der Impuls besonders erhöht, mit der die positiv geladenen Ionen auf die Substratoberfläche prallen. Dadurch verändert sich der Aufbau der Schicht in Richtung eines geringeren Anteils an organischen (in der Regel vorwiegend aus C und H bestehenden) Gruppen und eines dementsprechend höheren Anteils an Si und O.

Erfindungsgemäß bevorzugt wird im erfindungsgemäßen Verfahren keine separate Ionenquelle verwendet.

Ohne durch eine bestimmte Theorie festgelegt sein zu wollen, wird davon ausgegangen, dass eine erhöhte Impulswucht, wie etwa durch ein verstärktes Ionenbombardement, das Abschlagen von organischen Gruppen sowohl in den schichtbildenden Ionen (des Plasmas) als auch in der entstehenden Beschichtung erleichtert, wobei die abgespaltenen Gruppen eine geringe Wahrscheinlichkeit besitzen, in die Schicht eingebaut zu werden. Außerdem wird durch die Wucht der aufprallenden Ionen die innere Spannung (Eigenspannungen) der Schicht herabgesetzt, was die Dehnung bis zum Mikroriss der Schicht erhöht. Zur Messung der Dehnung bis Mikroriss (Rissdehnung) vergleiche Beispiel 1.

Die gleichen Beobachtungen (höhere Abscheiderate, geringerer Anteil organischer Gruppen, geringere innere Spannung, höhere Rissdehnung) werden gemacht, wenn der Self-Bias erhöht wird. Aus diesem Grund können harte Beschichtungen eine höhere Rissdehnung als weiche aufweisen. Bei sehr niedrigem Self-Bias fehlt eine ausreichende Wucht (Impact), die die Beschichtung entspannt, was zu weichen (z.B. durch Nanoindentation zu messende Härte von 1 GPa) und gleichzeitig rissempfindlichen Beschichtungen führen kann.

Wird allerdings der Self-Bias über einen vorteilhaften Bereich (siehe dazu auch oben) hinaus erhöht, so entstehen Beschichtungen, die einen zu geringen Anteil an organischen Gruppen und einen zu hohen Anteil von Si-H-Bindungen (siehe dazu auch unten) enthalten, wodurch sie zu hart und zu spröde werden und ihre Kratzfestigkeit abnimmt. Außerdem werden sie gelblich. Anzustreben ist somit ein Optimum im Hinblick auf die Härte und Elastizität der durch das erfindungsgemäße Verfahren hergestellten Beschichtung bei einem akzeptablen Gelbindex (siehe dazu auch unten).

Eine Erhöhung des Self-Bias bewirkt in der entstehenden Schicht einerseits den Abbau von Eigenspannungen und damit einen die Rissdehnung erhöhenden Effekt, andererseits eine Erhöhung der Härte und des Elastizitätsmoduls und damit einen die Rissdehnung verringernden Effekt. Dadurch, dass sich zwei gegenläufige Effekte teilweise aufheben, gibt es ein Optimum für die Rissdehnung in Abhängigkeit vom Self-Bias, so dass eine hervorragende Kombination von jeweils verhältnismäßig hoher Härte und hoher Rissbildung erzeugt werden kann.

Zusätzlich führt eine Erhöhung des Self-Bias zu einer erhöhten Abscheiderate der resultierenden Schicht.

Es handelt sich bei den mit dem erfindungsgemäßen Verfahren erzeugbaren Schichten um organisch modifizierte SiO₂-Gerüste. Die organischen Anteile lassen sich im IR-Spektrum durch Banden bei bei ca. 2950 cm⁻¹ und bei ca. 1275 cm⁻¹ nachweisen. Zudem können sie durch Messung der Oberflächenenergie mit Testtinten nachgewiesen werden, da die Oberflächenenergie mit dem Anteil organischer Gruppen absinkt. können. Je höher der Anteil organischer Gruppen, desto geringer ist die Oberflächenenergie. Daher ist die Oberflächenenergie umso größer, je höher der Self-Bias eingestellt wird.

Im Stand der Technik ist das Anordnen des Substrats in einer Weise, dass es als Kathode wirkt, im Allgemeinen nicht bevorzugt, da dies die Gefahr des Ausbildens undefinierbarer siliciumorganischer Schichten auf dem Substrat birgt und dem Wunsch nach einem relativ hohen Anteil organischer Gruppen in der Schicht entgegenläuft. Die organische Modifikation erhöht die Flexibilität und Elastizität der erzeugten Schicht. Zudem setzt sie ihre Eigenspannungen (innere Spannung) herab, wodurch die Rissdehnung der Schicht erhöht wird.

Vorzugsweise wird in einem erfindungsgemäßen Verfahren während Schritt B der Self-Bias auf dem Substrat eingestellt. Die Abhängigkeit der Abscheiderate und der Schichteigenschaften vom Self-Bias wurde bereits erläutert. Wird der Self-Bias direkt auf dem Substrat und somit auf dem zu beschichtenden Gegenstand eingestellt, so erleichtert dies das Erzielen einer Schicht mit den gewünschten genau definierten Eigenschaften.

Vorzugsweise erfolgt in einem erfindungsgemäßen Verfahren während Schritt B eine Regelung, so dass der Self-Bias konstant ist. Hierdurch kann der Aufbau der Schicht zeitlich genau kontrolliert werden. Vorteile eines möglichst konstanten Self-Bias sind ein homogener Schichtaufbau und eine einfache Prozessübertragung auf verschiedenartige Substrate oder eine Mehrzahl von Substraten. Vorzugsweise wird während Schritt B direkt der Self-Bias geregelt. Wird die Plasmaleistung geregelt, so wird in der Regel der Self-Bias nicht völlig konstant sein, sondern um einen bestimmten Wert fluktuieren. In einem solchen Fall ist es bevorzugt, wenn die Gesamtschwankungsbreite des Self-Bias maximal 5% des zeitlichen Mittelwertes beträgt, vorzugsweise maximal 3%.

Besonders bevorzugt ist ein erfindungsgemäßes Verfahren (insbesondere in Kombination mit einem oder mehreren Merkmalen eines anderen als bevorzugt oder besonders bevorzugt beschriebenen Verfahrens), wobei während Schritt B eine Regelung erfolgt, so dass der Self-Bias auf dem Substratim Bereich von 100 bis 300 V, liegt, so, dass der Self-Bias konstant ist.

Weiterhin besonders bevorzugt ist ein erfindungsgemäßes Verfahren (insbesondere in Kombination mit einem oder mehreren Merkmalen eines anderen als bevorzugt oder besonders bevorzugt beschriebenen Verfahrens), wobei der an der Elektrode anliegende Bias nicht allein durch die Plasmaprozessparameter bestimmt wird, sondern durch eine zusätzliche externe Gleichspannung. Dies ist insbesondere dann wichtig, wenn die Elektrodenfläche groß gewählt wird.

Bevorzugt ist ein erfindungsgemäßes Verfahren, wobei sich in Schritt B das Kunststoffsubstrat in räumlichem Kontakt (oder in unmittelbarer Nähe) mit der Kathode befindet. Durch das Herstellen eines räumlichen Kontaktes wird die Anordnung des Substrats im Plasmapolymerisationsreaktor erleichtert, es kann eine bewegte Folienbahn in einem Rolle zu Rolle Verfahren beschichtet werden.

Eine Erhöhung des Zuflusses des oder der siliciumorganischen Precursoren für das Plasma, (im Verhältnis zu gegebenenfalls ebenfalls zufließendem O₂, insbesondere unter Konstanthalten des Gesamtzuflusses) bewirkt im Allgemeinen eine Erniedrigung der Härte, eine Erhöhung der Absorption im sichtbaren Bereich (Erhöhung des Gelbindex) und eine Erhöhung der Rissdehnung.

Bei einer hohen Anzahl von Si-H-Bindungen in einer erfindungsgemäßen Schicht kann im UV/Vis-Spektrum eine erhöhte Absorption von Licht des ultravioletten und blauen Spektralbereichs festgestellt werden. Diese führt zu einer unerwünschten Gelbfärbung (Erhöhung des Gelbindex). Es ist daher wünschenswert, den Anteil an Si-H-Bindungen nicht zu groß werden zu lassen. Eine Verringerung des Self-Bias verhindert die Ausbildung von Si-H-Bindungen in der Beschichtung. Ebenfalls inhibieren lässt sich die Ausbildung von Si-H-Bindungen durch eine geeignete Auswahl der Menge und/oder Art an Precursor(en). Dies wird in der Regel durch eine Verringerung des Zuflusses an siliciumorganischen Precursoren erreicht, die darüber hinaus auch den Anteil an organischen Gruppen in der Beschichtung reduziert. Das Auftreten von Si-H-Bindungen lässt sich auch im IR-Spektrum (2150 bis 2250 cm⁻¹) nachweisen.

Die Ausbildung von Si-H-Bindungen in der Beschichtung wird ebenfalls verringert, wenn dem Plasma eine hinreichende Menge an Sauerstoff zugeführt wird, was darüber hinaus auch den Anteil an organischen Gruppen in der Beschichtung reduziert. Bevorzugt ist ein erfindungsgemäßes Verfahren, wobei in Schritt B dem Plasma Sauerstoff (in Form von O₂) zugeführt wird und vorzugsweise alle dem Plasma in Schritt B zugeführten Stoffe vor Eintritt in den Plasmapolymerisationsreaktor gasförmig sind. Eine Verfahrensführung in der Art, dass die dem Plasma zugeführten Stoffe nicht nur unter den Bedingungen des Plasmas, sondern bereits vor dem Eintritt in den Reaktor gasförmig sind, erleichtert die genaue Abstimmung der Dosierung der Stoffe.

Eine Erhöhung des Sauerstoffzuflusses führt zu einer Erhöhung der Härte, einer Verringerung der Absorption im sichtbaren Bereich (Verringerung des Gelbindex), zu einer Verbesserung der Korrosionsschutzwirkung, zu einer Verringerung der Anteile von organischen Gruppen in der Beschichtung und zu einer Erniedrigung der Rissdehnung.

In einem bevorzugten erfindungsgemäßen Verfahren wird dem Plasma Sauerstoff (O₂) zugeführt, sind alle dem Plasma in Schritt B zugeführten Stoffe vor Eintritt in den Plasmapolymerisationsreaktor gasförmig und liegt das Verhältnis der dem Plasma in Schritt B zugeführten Gasflüsse von Sauerstoff zu weiteren Precursor(en) (insbesondere siliziumorganischer Precursoren) im Bereich von 1:1 bis 6:1, vorzugsweise 3:1 bis 5:1. In diesem Bereich ist es erfindungsgemäß besonders einfach, den gewünschten Anteil von Kohlenstoff in der durch das Verfahren hergestellten Beschichtung einzustellen und die gewünschten Eigenschaften der Beschichtung zu erzielen.

Erhält man bei einem gegebenen Parametersatz eine gelbe Beschichtung, so kann der O₂-Fluss erhöht werden. Alternativ kann der Zufluss an dem oder den siliciumorganischen Precursoren oder der Self-Bias verringert werden. Ist die Beschichtung zu hart und damit zu spröde, so kann die Self-Bias reduziert bzw. der Zufluss an dem oder den siliciumorganischen Precursoren erhöht werden.

Bevorzugt ist ein erfindungsgemäßes Verfahren, insbesondere in einer der als bevorzugt bezeichneten Ausgestaltungen, wobei in Schritt B als Precursor(en) für das Plasma ein oder mehrere Siloxane, gegebenenfalls Sauerstoff (O₂) sowie vorzugsweise keine weiteren Verbindungen eingesetzt werden. Siloxane, insbesondere Hexamethyldisiloxan (HMDSO), haben sich als besonders geeignete Precursoren erwiesen, um ein erfindungsgemäßes Verfahren zu führen, mit dem Beschichtungen mit der vorteilhaften Eigenschaftskombination hergestellt werden können. Vorzugsweise wird in einem erfindungsgemäßen Verfahren in Schritt B als Precursor(en) für das Plasma HMDSO, gegebenenfalls Sauerstoff sowie vorzugsweise keine weitere Verbindung eingesetzt. Eine Erhöhung des Zuflusses an HMDSO im Verhältnis zu Sauerstoff bewirkt u. a. eine Erniedrigung der Härte und eine Erhöhung der Absorption im sichtbaren Bereich.

Besonders bevorzugt ist ein erfindungsgemäßes Verfahren, in dem in Schritt B dem Plasma Sauerstoff zugeführt wird, alle dem Plasma in Schritt B zugeführten Stoffe vor Eintritt in den Plasmapolymerisationsreaktor gasförmig sind, das Verhältnis der dem Plasma in Schritt B zugeführten Gasflüsse von Sauerstoff und weiteren Precursor(en) im Bereich von 1:1 bis 6:1 liegt und als Precursor(en) für das Plasma HMDSO, Sauerstoff sowie insbesondere keine weitere Verbindung eingesetzt wird.

Vorzugsweise wird bei dem erfindungsgemäßen Verfahren die Plasmapolymerisation bei einer Substrattemperatur von weniger als 200°C, bevorzugt weniger als 180°C und/oder einem Druck von weniger als 1 mbar, bevorzugt im Bereich von 10⁻³ bis 10⁻¹ mbar durchgeführt. Falls der Druck während der Abscheidung zu hoch ist, kann eine unerwünschte Pulverbildung des abgeschiedenen Materials auftreten. Bei einem Druck kleiner als 10⁻³ mbar kann das Plasma nicht mehr gezündet werden.

Vorzugsweise wird in einem erfindungsgemäßen Verfahren Schritt B bis zu einer Dicke der abgeschiedenen Beschichtung von größer oder gleich 2 µm, bevorzugt größer oder gleich 4 µm durchgeführt. Eine höhere Dicke erhöht die Kratzschutzwirkung einer gegebenen Beschichtung.

Bevorzugt ist ein erfindungsgemäßes Verfahren, wobei in Schritt B die Abscheiderate auf einen Wert von größer oder gleich 0,2 µm/min, vorzugsweise größer oder gleich 0,3 µm/min, eingestellt wird. Es kann beispielsweise ein Wert von 0,5 µm/min gewählt werden. Hohe Abscheideraten erhöhen zum einen die Wirtschaftlichkeit des erfindungsgemäßen Verfahrens und erleichtern zudem die Einstellung der gewünschten Schichteigenschaften.

Bei einem bevorzugten erfindungsgemäßen beschichteten Kunststoffsubstrat weist ein von der Beschichtung aufgenommenes IR-Spektrum eine oder mehrere, vorzugsweise alle der folgenden Banden (Peaks) mit einem jeweiligen Maximum in den folgenden Bereichen auf: C-H-Valenzschwingung im Bereich von 2950 bis 2970 cm⁻¹, Si-H-Schwingung im Bereich von 2150 bis 2250 cm⁻¹, Si-CH₂-Si-Schwingung im Bereich von 1350 bis 1370 cm⁻¹, Si-CH₃-Deformationschwingung im Bereich von 1250 bis 1280 cm⁻¹ und Si-O-Si-Schwingung bei größer oder gleich 1150 cm⁻¹.

Die Lage des Maximums der Si-O-Si-Schwingung gibt Aufschluss über den Vernetzungsgrad der Schicht. Je höher seine Wellenzahl, desto höher der Vernetzungsgrad. Schichten, bei denen dieses Maximum bei größer oder gleich 1200 cm⁻¹, vorzugsweise größer oder gleich 1250 cm⁻¹ liegt, haben einen hohen Vernetzungsgrad, während etwa Antihaftschichten mit diesem Maximum bei typischerweise ca. 1100 cm⁻¹ einen geringen Vernetzungsgrad besitzen.

Eine nachweisbare Si-CH₂-Si-Schwingungsbande zeigt an, dass zusätzlich zu Si-O-Si-Verknüpfungen, Si-CH₂-Si-Verknüpfungen in der Beschichtung vorhanden sind. Ein solches Material weist regelmäßig eine erhöhte Flexibilität und Elastizität auf.

Zur Charakterisierung der Beschichtung kann das Verhältnis der Intensität der Si-H-Bande zur Intensität der Si-CH₃-Bande dienen. Beschichtungen, bei denen dieses Verhältnis kleiner oder gleich ca. 0,2 ist, sind farblos. Bei einem Verhältnis von größer als ca. 0,3 sind die Beschichtungen gelblich. Bevorzugt ist ein erfindungsgemäßes beschichtetes Kunststoffsubstrat, wobei in einem von der Beschichtung aufgenommenen IR-Spektrum das Verhältnis der Intensität der Si-H-Bande zur Intensität der Si-CH₃-Bande kleiner oder gleich 0,3, vorzugsweise kleiner oder gleich 0,2 ist.

Bevorzugt ist ein erfindungsgemäßes beschichtetes Kunststoffsubstrat, wobei die Beschichtung eine Absorptionskonstante k_{300 nm} von kleiner oder gleich 0,05 und/oder eine Absorptionskonstante k_{400 nm} von kleiner oder gleich 0,01 aufweist. Der Zusammenhang der Anzahl von Si-H-Bindungen, welche eine Lichtabsorption im ultravioletten und blauen Bereich hervorrufen, mit dem Self-Bias, einer Sauerstoffzufuhr zum Plasma und der Menge und Art an Precursor(en) wurde bereits oben erläutert.

Vorzugsweise weist die Beschichtung eines erfindungsgemäßen beschichteten Kunststoffsubstrats eine Oberflächenenergie im Bereich von 20 bis 40 mN/m, bevorzugt 25 bis 35 mN/m auf. Die Oberflächenenergie wird wie oben ausgeführt durch die Anteile an organischen Gruppen und somit unter anderem durch den Betrag des Self-Bias bestimmt.

Wie oben ausgeführt, wird die Rissdehnung u. a. durch die Einstellung des Self-Bias bestimmt. Bei einem bevorzugten erfindungsgemäßen Kunststoffsubstrat weist die Beschichtung eine Dehnung der plasmpolymeren Beschichtung bis Mikroriss (Rissdehnung) von größer oder gleich 2,5%, vorzugsweise größer oder gleich 2,75%, weiter bevorzugt größer oder gleich 3% auf.

Der Self-Bias beeinflusst die Schichtdickenhomogenität in der oben genannten Weise. Im Fall von größeren Reaktoren sind jedoch auch die Gasflüsse von großer Bedeutung. Hierunter sind beispielsweise solche Reaktoren zu verstehen, bei denen die Reaktorkammer (Rezipient) 2 m³ oder größer ist. Die Schichtdickenhomogenität u.a. wird durch die auf dem Substrat erzeugten elektrischen Felder definiert, d.h. eine hohe Feldstärke bedeutet eine hohe Abscheiderate. Homogenität ist nur dann zu erzielen, wenn die elektrische Feldstärke auf dem Substrat überall weitgehend gleich ist. Allgemein gilt: Die Schichtdickenhomogenität auf dem beliebigen dreidimensionalen Substrat gehorcht der Laplace-Gleichung, die die Lösung für die elektrische Feldstärke auf dem Substrat angibt. Vorzugsweise unterscheidet sich in einem erfindungsgemäßen beschichteten Kunststoffsubstrat die maximale Schichtdicke von der minimalen Schichtdicke um den Faktor 1,1 oder geringer. Demzufolge sind auf einer Kunststofffolie hervorragende Schichtdickenhomogenitäten erzielbar, auch wenn die Folienoberfläche geometrische Strukturen aufweisen sollte.

Teil der Erfindung ist auch ein Verfahren zur Herstellung eines Bauteiles mit einer Kratzschutzschicht, umfassend die Schritte:
a) Herstellen einer beschichteten Kunststofffolie mittels eines erfindungsgemäßen Verfahrens (als Zwischenprodukt),
b) Bereitstellen eines Trägermaterials und
c) Verbinden des Trägermaterials mit der beschichteten Kunststofffolie mit dem Bauteil, so dass die Beschichtung der Kunststofffolie vom Trägermaterial weggerichtet ist.

Das Trägermaterial kann dabei z.B. ein bereits weitgehend fertiges, geformtes Bauteil sein, das lediglich noch beschichtet werden muss oder auch ein flüssiger Kunststoff, wie er z.B. beim Hinterspritzen eingesetzt wird. Das Trägermaterial kann grundsätzlich auch eine Zwischenschicht sein, die ihrerseits wiederum mit weiteren Materialien/Bauteilen verbunden werden kann. Die Auswahl des geeigneten Trägermaterials ist dabei von dem eingesetzten Herstellungsverfahren und selbstverständlich auch von der Funktion des Bauteiles abhängig.

Dabei erfolgt bevorzugt die Weiterverarbeitung des Zwischenproduktes mit Hilfe eines Kunststoffverarbeitungsverfahrens, welches das Zwischenprodukt verformt und/oder mit dem (entstehenden) Bauteil (typischerweise Kunststoff, aber im Einzelfall auch andere Materialien wie Metall oder Holz) verbindet. Dabei wird die ehemals beschichtete Kunststofffolie des Zwischenproduktes zum integralen Bestandteil des Bauteils. Die Beschichtung ist vom Bauteil weggerichtet.

Ein Bauteil kann dabei im Prinzip aus beliebigen geeigneten Materialien bestehen, auf die eine Kunststofffolie aufgebracht werden kann, das erfindungsgemäß durchzuführende Verfahren als Kunststoffsubstrat dienen kann. Bauteile können einfache oder auch komplexe Gegenstände sein. Bevorzugte Bauteile sind Kunststoffformteile.

Bevorzugt ist ein erfindungsgemäßes Verfahren zur Herstellung eines Bauteils mit einer Kratzschutzschicht, wobei im Schritt c) durch Laminieren, In-mould Labeling, Kaschieren, Heißprägen, Spritzgießen, Blasformen, Pressen, Hinterspritzen, Hinterprägen, Spritzprägen, Thermoformen, Strangablegen oder einer Kombination zweier oder mehrere dieser Verfahren erfolgt.

Ganz besonders werden im erfindungsgemäßen Verfahren zur Herstellung eines Bauteils im Schritt c) die folgenden Techniken eingesetzt:
Klebekaschieren / Laminieren

Bei diesem Verfahren wird ein Dekormaterial (hier Kunststofffolie mit Kratzschutzschicht aus erfindungsgemäßem Verfahren) in einem separaten Prozessschritt auf das Trägerteil aufgeklebt. Als Trägerbauteile kommen hier spritzgegossene, meist thermoplastische Träger oder aber gepresste Träger aus Holzfaserpressstoff oder sonstigen nachwachsenden Rohstoffen, wie beispielsweise Hanf, Kokos etc. zum Einsatz.

### In-mould Labeling (IML)

Beim In-mould Labeling wird die Formteiloberfläche im Spritzgießwerkzeug mit bedruckten und der Kontur entsprechend ausgestanzten Etikettenfolien (hier Kunststofffolie mit Kratzschutzschicht aus erfindungsgemäßem Verfahren) versehen. Die fertigen Folien werden mit einem Handlingsystem in das Spritzgusswerkzeug eingebracht und dort fixiert. Anschließend wird die Schmelze eingespritzt und die bedruckte Folie verbindet sich unlösbar mit dem Träger.

### Folienhinterspritztechnik

Dieser Begriff dient als Oberbegriff zur Verarbeitung unterschiedlicher kompakter oder mehrschichtiger Foliensorten (hier Kunststofffolie mit Kratzschutzschicht aus erfindungsgemäßem Verfahren). Unterbegriffe sind beispielsweise In-mould Surfacing, In-mould Surfacing Film (ISF) oder Paintless Film Moulding (PFM).

Bei der Folienhinterspritztechnik wird eine den Anforderungen entsprechend bedruckte, kompakte oder mehrschichtige Dekorfolie für die häufigsten Anwendungen zunächst vorgeformt und eventuell besäumt. Anschließend wird die Folie in das Spritzgießwerkzeug eingelegt, fixiert und durch das Einspritzen der Formmasse unlösbar mit dem Träger verbunden. Man unterscheidet einstufige und mehrstufige Folienhinterspritzverfahren. Im letzteren Fall wird die Folie durch den Werkzeugkern im kalten Zustand (dreidimensional) teilverformt; die endgültige Formgebung erfolgt durch den Hinterspritzvorgang. Hierdurch werden komplexere Formteile möglich.

Es werden auch in einem separaten Prozess vorgeformte Folien im Folienhinterspritzprozess verarbeitet.

In mehrstufigen Oberflächendekorationsverfahren, wie z.B. dem Laminieren und Beschichten erfolgt der eigentliche Dekorierprozess nach der Herstellung eines geeigneten Trägerbauteils. Demgegenüber wird in einstufigen Verfahren das Dekor (hier Kunststofffolie mit Kratzschutzschicht aus erfindungsgemäßem Verfahren) während des Urformprozesses des Trägers unlösbar mit diesem verbunden. Als Urformprozess wird in der Regel das Spritzgießverfahren eingesetzt. In Sonderfällen wird auch die Spritzprägetechnik angewendet.

### Folienverformung

Unter Folienverformung versteht man eine Konturausbildung durch plastische Dehnung der Folie. Sie unterscheidet sich von der Anformung einer geometrisch abwickelbaren Oberfläche an die Werkzeugkontur, wie sie beispielsweise vorwiegend beim In-mould Labeling angewendet wird.

Grundsätzlich sind dem Fachmann eine Reihe weiterer Anwendungsgebiete für die im erfindungsgemäßen Verfahren erzeugten Folien mit einer Kratzschutzschicht zur Herstellung von Bauteilen bekannt, die er sinnvoll einsetzen wird.

Bestandteil der Erfindung sind auch die mit dem erfindungsgemäßen Beschichtungsverfahren herstellbaren beschichteten Kunststoffsubstrate und Bauteile. Bevorzugte Ausgestaltungen dieser Bauteile und beschichteten Substrate lassen sich als Produkte der oben genannten bevorzugten Verfahren entnehmen sowie aus den Ansprüchen.

Teil der Erfindung ist auch die Verwendung einer in einem erfindungsgemäßen Verfahren herstellbaren beschichteten Kunststofffolie oder eines beschichteten Kunststoffsubstrates, das eine beschichtete Kunststofffolie ist, in Verfahren zum Laminieren, Kaschieren, Heißprägen, Spritzgießen, Blasformen, Pressen, Hinterspritzen, Hinterprägen, Spritzprägen, Thermoformen, Strangablegen, bevorzugt als Laminier- oder Kaschierfolie und/oder als Folie für thermische Formgebungsverfahren und/oder als Folie zum Hinterspritzen.

Bei dieser erfindungsgemäßen Verwendung lässt sich wiederum die überraschende Flexibilität der plasmapolymeren Schicht ausnutzen. Die Flexibilität ist insbesondere deshalb überraschend, weil die plasmapolymere Kratzschutzschicht kein thermoplastisches Material ist, sondern von ihrer Zusammensetzung her am ehesten Gläsern oder Duroplasten zuzuordnen ist.

Weitere Aspekte der vorliegenden Erfindung ergeben sich aus den nachfolgenden Beispielen, den Zeichnungen und den Ansprüchen.

### Beispiele:

### Beispiel 1: XPS

XPS-Messungen (ESCA-Messungen) wurden mit dem Spektrometer KRATOS AXIS Ultra der Firma Kratos Analytical durchgeführt. Die Kalibrierung des Messgerätes wurde so vorgenommen, dass der aliphatische Anteil des C 1s Peaks bei 285,00 eV liegt. Aufgrund von Aufladungseffekten wird es in der Regel notwendig sein, die Energieachse ohne weitere Modifikation auf diesen Fixwert zu verschieben. Die Analysekammer war mit einer Röntgenquelle für monochromatisierte AI K_{α}-Strahlung, einer Elektronenquelle als Neutralisator und einem Quadrupolmassenspektrometer ausgerüstet. Weiterhin verfügte die Anlage über eine magnetische Linse, welche die Photoelektronen über einen Eintrittsschlitz in einen Halbkugelanalysator fokussierte. Während der Messung zeigte die Oberflächennormale auf den Eintrittsschlitz des Halbkugelanalysators. Die Passenergie betrug bei der Bestimmung der Stoffmengenverhältnisse jeweils 160 eV. Bei der Bestimmung der Peak-Parameter betrug die Passenergie jeweils 20 eV.

Die genannten Messbedingungen sind bevorzugt, um eine weitgehende Unabhängigkeit vom Spektrometertyp zu ermöglichen und um erfindungsgemäße plasmapolymere Produkte zu identifizieren.

Als Referenzmaterial wurde das Polydimethylsiloxan Silikonöl DMS-T23E der Firma Gelest Inc. (Morrisville, USA) verwendet. Dieses trimethylsiloxy-terminierte Silikonöl besitzt eine kinematische Viskosität von 350 mm²/s (±10%) und eine Dichte von 0,970 g/mL bei 25 °C sowie ein mittleres Molekulargewicht von ca. 13 650 g/mol. Das ausgewählte Material zeichnet sich durch einen extrem geringen Anteil an verdampfbaren Bestandteilen aus: nach 24 Stunden bei 125 °C und 10⁻⁵ Torr Vakuum wurden weniger als 0,01% flüchtige Anteile nachgewiesen (nach ASTM-E595-85 und NASA SP-R0022A). Es wurde mit Hilfe eines Spin-Coating-Prozesses als 40 bzw. 50 nm dicke Schicht auf einen Siliziumwafer aufgetragen; dabei wurde als Lösemittel Hexamethyldisiloxan verwendet.

Mit der oben beschriebenen Vorgehensweise ergibt sich für das Silkonöl DMS-T23E folgende atomare Zusammensetzung. Die Bindungsenergien der Elektronen sind ebenfalls aufgeführt.

**Tabelle 1: Chemische Zusammensetzung und Bindungsenergie von Silikonöl DMS-T23E**

| Element | Si | O | C |
|---|---|---|---|
| Konzentration [Atom-%] | 24,76 | 25,40 | 49,84 |
| Bindungsenergie [eV] | 102,39 | 532,04 | 285,00 |

### Beispiel 2: Messung der Härte mittels Nanoindentation

Die Nanoindentationshärte einer Probe wurde mit Hilfe eines Berkovich-Indenter (Hersteller: Hysitron Inc. Minneapolis, USA) bestimmt. Die Kalibrierung und Auswertung geschah nach dem etablierten Verfahren von Oliver & Pharr (J. Mater. Res. 7, 1564 (1992)). Die Maschinensteifigkeit und die Flächenfunktion des Indenters wurden vor der Messung kalibriert. Bei der Indentation wurde das "multiple partial unloading"-Verfahren (Schiffmann & Küster, Z. Metallkunde 95, 311 (2004)) benutzt, um tiefenabhängige Härtewerte zu erhalten und so einen Substrateinfluss ausschließen zu können.

### Beispiel 3: Dehnung bis Mikroriss (Rissdehnung)

Zur Bestimmung des Wertes für Dehnung des Mikrorisses wird ein 0,5 mm dünnes und 10 cm langes Aluminiumblech analog beschichtet und so lange gedehnt, bis optische Risse sichtbar werden. Die Rissdehnungsgrenze ist gleich dem Quotienten aus Längenänderung zur Ursprungsgesamtlänge des Aluminiums.

### Beispiel 4: IR-Spektroskopie und Bestimmung des Intensitätsverhältnisses zweier Banden im IR-Spektrum

Die Messungen wurden mit einem IFS 66/S IR-Spektrometer der Firma Bruker durchgeführt. Als Verfahren wurde die IRRAS-Technik eingesetzt, mit deren Hilfe auch dünnste Beschichtungen vermessen werden können. Die Spektren wurden im Wellenzahlbereich von 700 bis 4000 cm⁻¹ aufgenommen. Als Substratmaterial wurden kleine Plättchen von sehr sauberem und besonders ebenem Aluminium verwendet. Der Einfallswinkel des IR-Lichts betrug bei der Messung 50°. Während sich die Probe im IR-Spektrometer befand, wurde die Probenkammer fortwährend mit trockener Luft gespült. Das Spektrum wurde unter solchen Bedingungen aufgenommen, dass der Wasserdampfgehalt in der Probenkammer so klein war, dass im IR-Spektrum keine Rotationsbanden des Wassers zu erkennen waren. Als Referenz wurde ein unbeschichtetes Aluminiumplättchen verwendet.

Das Intensitätsverhältnis zweier Banden (Peaks) wird wie folgt bestimmt: Die Basislinie (Baseline) im Bereich eines Peaks wird durch die beiden Minima definiert, die das Maximum der Bande einschließen und entspricht der Strecke zwischen ihnen. Es wird vorausgesetzt, dass die Absorptionsbanden gaußförmig sind. Die Intensität einer Bande entspricht der Fläche zwischen Basislinie und Messkurve, begrenzt durch die beiden Minima, die das Maximum einschließen, und kann vom Fachmann nach bekannten Methoden einfach ermittelt werden. Die Bestimmung des Intensitätsverhältnisses zweier Banden erfolgt durch Bilden des Quotienten ihrer Intensitäten. Grundvoraussetzung für den Vergleich zweier Proben ist hierbei, dass die Beschichtungen die gleiche Dicke aufweisen und dass der Einfallswinkel nicht verändert wird.

### Beispiel 5: Dornbiegetest

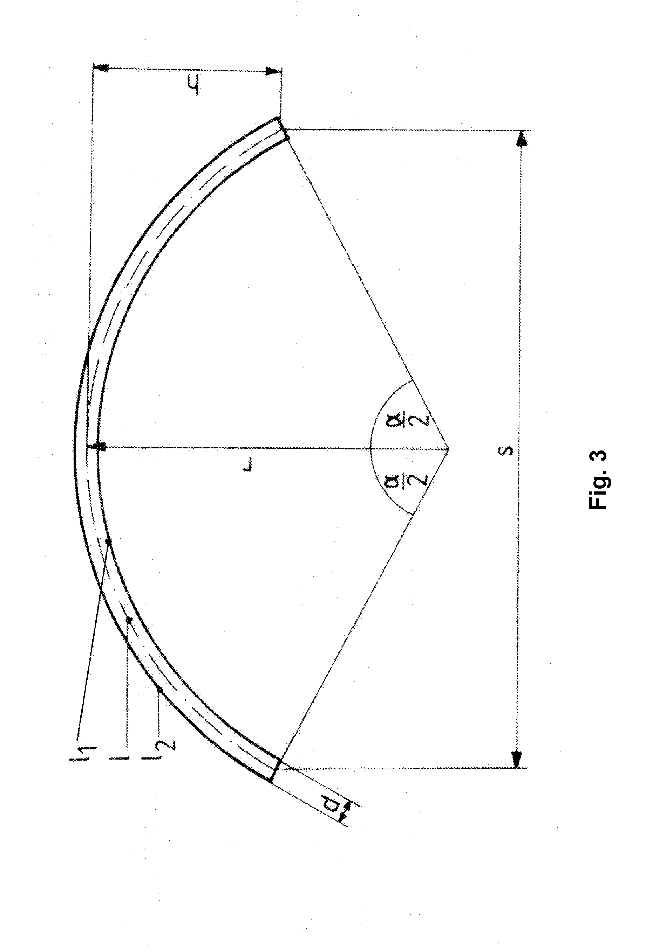

Der Dornbiegetest gemäß DIN EN ISO 1519 kann als alternatives Messverfahren zu Beispiel 3 für die Rissdehnung eingesetzt werden. Beschichtete Testbleche werden dabei über verschieden große, genau definierte zylindrische Dorne bis zu einem 180° Winkel gebogen bis Risse in der Beschichtung auftreten, die für die Messung relevanten Größen sind der Fig. 3 zu entnehmen.

### Anwendungsbeispiel 1 (Folienhinterspritzung)

Eine Purelay^{®}-Pharmafolie der Firma Etimex primary packaging GmbH wurde mit einer flexiblen plasmapolymeren Kratzschutzschicht versehen. Dabei wurden die Beschichtungsparamter nach Tabelle 1 gewählt. Die Beschichtung wurde durchgeführt in einer Plasmapolymerisationsanlage wie sie in "Aufskalierung plasmapolymerer Beschichtungsverfahren" (ISBN 978-3-86727-548-4) in Kapitel 3.2 näher beschrieben worden ist. Allerdings wurden hier die Stabelektroden durch eine flächige Plattenelektrode von ca. 200 x 300 mm ersetzt, auf der die Proben direkt aufgebracht waren. Die Folien bestehen aus transparentem Polypropylen mit einer Dicke von 0,3 mm.

Aus den beschichteten Folien wurden Stücke von etwa 40x60 mm ausgeschnitten und mit Klebestreifen in der Werkzeugkavität fixiert, wobei die Beschichtung zur Kavität zeigte, also nach Hinterspritzen an der Außenseite des Bauteils vorliegt.

Die Folien wurden hinterspritzt mit einem Polypropylen vom Typ 579S der Sabic AG.

Die Werkzeugtemperatur wurde auf 30°C eingestellt. Als Einspritzgeschwindigkeit wurden 20 ccm/s gewählt. Die Materialtemperatur wurde in einer ersten Versuchsreihe auf 220°C und in einer zweiten Versuchsreihe auf 240°C eingestellt.

Als Werkzeug wurde ein Stammwerkzeug mit austauschbaren Kavitätseinsätzen verwendet, sodass verschiedene Bauteilgeometrien gespritzt werden können. Dies ist zum einen ein wellenförmig geschwungenes Plattenbauteil (Radius 8 mm) mit einer Fläche von 125x70 mm. Angespritzt wird die Kavität über einen zentralen Stangenanguss. Die Folie erfuhr hierbei eine rechnerische Dehnung von ca. 1,6% aufgrund der Kavitätsgeometrie. Weiterhin wurden plattenförmige Bauteile mit tastenförmigen, runden und eckigen Erhebungen von 0,3 bis 2 mm Höhe gespritzt. Die Bauteilabmessungen betragen 175x80 mm. Angespritzt wurde die Kavität wiederum über einen zentralen Stangenanguss. Im Randbereich der tastenförmigen Erhebungen findet eine sehr starke Dehnung der beschichteten Folie statt. Diese äußert sich in diesem Bereich durch entsprechende Dehnungsrisse.

Als Spritzgießmaschine wurde eine Demag Ergotech 80/420-320 mit 80 t Schließkraft, einem Schneckendurchmesser von 30 mm bei einem Längen-/Durchmesserverhältnis von 20 verwendet.

Die Beobachtungen zeigen, dass die flexible Kratzfestbeschichtung die Hinterspritzung erfolgreich übersteht und das entstehende Kunststoffbauteil vor Abrasion schützen kann. Risse, die in lokalen überdehnten Bereichen, wie z.B. den tastenförmigen Erhebungen, zu beobachten sind, breiten sich nicht aus. Im Bereich der ebenen Bauteiloberfläche zeigen sich an wenigen Stellen Fehlstellen in der Beschichtung. Diese Fehlstellen sind in Bereichen hoher Schwindung zu finden. Höchstwahrscheinlich wird die Beschichtung in Folge der thermisch bedingten Schwindung des Bauteils gestaucht und Stellen reduzierter Schichthaftung sorgen für die mikroskopisch leicht flächigen Fehlstellen.

Um die Dehnbarkeit der Beschichtung bis zur Rissbildung zu untersuchen wurde statt der Kunststofffolie ein 1,5 mm dickes Aluminiumblech, da es sich gleichmäßig biegen lässt, nach den gleichen Parametern beschichtet, um es dann im Halbkreis um einen Dorn zu biegen. Bei einer abgeschiedenen Schichtdicke von 4µm kann die Reißdehnung ε = (I₂-I₁/I₁) * 100% nach Fig. 3 berechnet werden. Die Ergebnisse bis zum Erscheinen von Mikrorissen in der Beschichtung finden sich in Tabelle 2. Alle Proben, die keine Rissbildung zeigten, schützen auch vor Korriosion, so dass hier nicht sichtbare Risse ebenfalls ausgeschlossen werden können.

**Tabelle 1:**

| Schritt 1 | | |
|---|---|---|
| HMDSO | (sccm) | 0 |
| O2 | (sccm) | 140 |
| Zeit | (sec) | 60 |
| Druck | (mbar) | 0,03 |
| Bias | (V) | 250 |
| | | |

| Schritt 2 | | |
|---|---|---|
| HMDSO | (sccm) | 40 |
| O2 | (sccm) | 140 |
| Zeit | (sec) | 1800 |
| Druck | (mbar) | 0,035 |
| Bias | (V) | 250 |

**Tabelle 2**

| Biegeradius | Rissdehnung (%) | Rissbildung (Ja/Nein) |
|---|---|---|
| 35 mm | 2,2 | Nein |
| 30 mm | 2,5 | Nein |
| 25 mm | 3,01 | Nein |
| 20 mm | 3,6 | Ja |

### Anwendungsbeispiel 2 (Folienhinterspritzung):

Beispiel 2 wurde analog zu Beispiel 1 durchgeführt, jedoch jetzt mit den Beschichtungsparametern nach Tabelle 3. Diese Parameter zeichnen sich dadurch aus, dass weniger Eigenspannungen in die Folie eingebracht werden und die Haftung der Beschichtung optimiert ist.

Die Folien wurden hinterspritzt mit einem schwarz eingefärbten Polypropylen vom Typ. Polyfort FPP 20T der A. Schulmann GmbH. Das Material ist gegenüber dem in Beispiel 1 verwendeten Material durch eine Zugabe von 20% Talkum schwindungsoptimiert. Dies hat zur Folge, dass das Bauteil im Verlauf der Abkühlung weniger schwindet und die Folie und damit die Beschichtung entsprechend weniger gestaucht werden, was die Ausbildung von Druckspannungsinduzierten Schichtdefekten minimiert.

Die Werkzeugtemperatur wurde auf 50°C eingestellt. Als Einspritzgeschwindigkeit wurden 20 ccm/s gewählt. Die Materialtemperatur wurde auf 250°C eingestellt.

Als Werkzeug wurde wiederum ein Stammwerkzeug mit austauschbaren Kavitätseinsätzen verwendet, sodass verschiedene Bauteilgeometrien gespritzt werden können. Hier wurden wieder plattenförmige Bauteile mit tastenförmigen, runden und eckigen Erhebungen von 0,3 bis 2 mm Höhe gespritzt. Die Bauteilabmessungen betragen 175x80 mm. Angespritzt wird die Kavität wiederum über einen zentralen Stangenanguss. Im Randbereich der tastenförmigen Erhebungen findet eine sehr starke Dehnung der beschichteten Folie statt.

Die dehnfähige Abrasionsschutzbeschichtung auf der Folie ist nach dem Hinterspritzen und Abkühlen in der Fläche vollständig frei von Rissen. Selbst die Rissbildung in überdehnten Bereichen ist stark herab gesetzt. Auffällig ist, dass selbst im Bereich der tastenförmigen Erhebungen auch unter Kunstlicht fast keine Interferenzeffekte sichtbar werden, wie es bei der heute üblichen nachträglich Beschichtung zu erwarten ist. Die Reduktion des Materialschrumpfes mit der Verbesserung der Schichthaftung führt zu einem wesentlich verbesserten Erscheinungsbild gegenüber Anwendungsbeispiel 1.

Darüber hinaus sind der Glanzgrad und die Tiefenwirkung der schwarzen Bauteilfarbe deutlich erhöht. Dies ist auf eine Glättung der Oberfläche und damit auf eine Reduktion der Streuung zurück zu führen (siehe Tabelle 4)

**Tabelle 3:**

| Schritt 1 | | |
|---|---|---|
| HMDSO | (sccm) | 0 |
| O2 | (sccm) | 140 |
| Zeit | (sec) | 180 |
| Druck | (mbar) | 0,025 |
| Bias | (V) | 100 |
| | | |

| Schritt 2 | | |
|---|---|---|
| HMDSO | (sccm) | 30 |
| O2 | (sccm) | 15 |
| Zeit | (sec) | 60 |
| Druck | (mbar) | 0,035 |
| Bias | (V) | 100 |
| | | |

| Schritt 3 | | |
|---|---|---|
| HMDSO | (sccm) | 35 |
| O2 | (sccm) | 75 |
| Zeit | (sec) | 1800 |
| Druck | (mbar) | 0,035 |
| Bias | (V) | 100 |
| | | |

| Schritt 4 | | |
|---|---|---|
| HMDSO | (sccm) | 40 |
| O2 | (sccm) | 140 |
| Zeit | (sec) | 1800 |
| Druck | (mbar) | 0,035 |
| Bias | (V) | 250 |
| | | |

**Tabelle 4:**

| Oberfläche | Rauhwert nach DIN 4768 |
|---|---|
| Nicht hinterspritzte Oberfläche | Ra = 0,58 |
| Hinterspritzte Oberfläche | Ra = 0,34 |

### Anwendungsbeispiel 3 (Folienlaminierung)

Hier wurde die Beschichtung entsprechend Tabelle 1 auf handelsüblicher Laminierfolie auf Polyesterbasis (Dicke 0,082 µm) aufgebracht und auf einem Laminiergerät DocuSeal 95 der Fa. GBC General Binding Corporation, Northbrook, Ilinois verarbeitet. Anschließend wurde die so beschichtete Laminierfolie mit einer unbeschichteten Laminierfolie zu einem Verbund zusammenlaminiert.

Hieraus resultiert ein transparenter, rissfreier Folienverbund, der auf der beschichteten Seite eine hervorragende Kratzfestigkeit aufweist. Dieses wurde mit handelsüblichen Kunststofftopfschwämmen (harte Seite) überprüft. Ferner ist der Folienverbund in allen Richtungen ohne Rissbildung biegbar, solange bis die Basisfolie überdehnt wird.

## Patentansprüche

1. Verfahren zum Beschichten der Oberfläche eines Kunststoffsubstrates, mit folgenden Schritten:
A. Bereitstellen des Kunststoffsubstrates und gegebenenfalls Säubern der zu beschichtenden Substratoberfläche,
B. Beschichten der gegebenenfalls in Schritt A gesäuberten Substratoberfläche in einem Hochfrequenzplasmapolymerisationsreaktor mittels Plasmapolymerisation, wobei in Schritt B
- als Precursor(en) für das Plasma eine oder mehrere siliciumorganische sowie (a) keine weiteren oder (b) weitere Verbindungen eingesetzt werden und das Kunststoffsubstrat im Hochfrequenzplasmapolymerisationsreaktor so angeordnet wird, dass es sich zwischen der Zone, in der das Plasma gebildet wird, und der Kathode befindet,
eine Regelung erfolgt, so dass der Self-Bias im Bereich von 100 bis 300 V liegt,
**dadurch gekennzeichnet, dass** das Verfahren so geführt wird, dass die durch das Verfahren hergestellte Beschichtung
- einen durch Messung mittels XPS bestimmbaren Anteil von Kohlenstoff von 3 bis 28 Atom-% vorzugsweise 5 bis 28 Atom-%, weiter vorzugsweise 7 bis 28 Atom-%, bezogen auf die Gesamtzahl der in der Beschichtung enthaltenen Kohlenstoff-, Silicium- und Sauerstoffatome aufweist.
- eine Rissdehnung von ≥ 2,5 %
- einen nach ASTM D 1925 bestimmten Gelbindex (Yellow Index) von ≤ 3, vorzugsweise ≤ 2,5 und
- eine mittels Nanoindentation zu messende Härte im Bereich von 2,5 bis 6 GPa, vorzugsweise 3,1 bis 6 GPa
aufweist.

2. Verfahren nach Anspruch 1, wobei das Kunststoffsubstrat eines, mehrere oder alle Merkmale aufweist aus der Gruppe bestehend aus:
- Transparenz oder Teiltransparenz im Bereich des sichtbaren Lichtes
- das Kunststoffsubstrat ist eine Folie, bevorzugt aus einem Material ausgewählt aus der Gruppe bestehend aus PVC, PE, PP, PC, PMMA, PET, POM und TPU,
- das Kunststoffsubstrat ist ein Thermoplast oder Elastomer oder ein thermoplastisches Elastomer.

3. Verfahren nach einem der vorangehenden Ansprüche, wobei in Schritt B
- dem Plasma Sauerstoff zugeführt wird und vorzugsweise alle dem Plasma in Schritt B zugeführten Stoffe vor Eintritt in den Plasmapolymerisationsreaktor gasförmig sind und das Verhältnis der dem Plasma in Schritt B zugeführten Gasflüsse von Sauerstoff und weiteren Precursor(en) im Bereich von 1:1 bis 6:1, vorzugsweise 3:1 bis 5:1 liegt,
und/oder
- als Precursor(en) für das Plasma ein oder mehrere Siloxane, vorzugsweise Hexamethyldisiloxan (HMDSO), gegebenenfalls Sauerstoff sowie vorzugsweise keine weiteren Verbindungen eingesetzt werden.

4. Verfahren nach einem der vorangehenden Ansprüche, wobei während Schritt B eines, mehrere oder alle Merkmale erfüllt sind aus der Gruppe bestehend aus:
- Einstellung des Self-Bias auf dem Substrat, vorzugsweise unter Zuhilfenahme einer externen Gleichspannungsquelle
- Regelung, so dass die Gesamtschwankungsbreite des Self-Bias maximal 5%, vorzugsweise maximal 3% des zeitlichen Mittelwertes beträgt
- Kontakt des Kunststoffsubstrats mit der Kathode
- Durchführung der Plasmapolymerisation bei einer Temperatur von weniger als 200°C
- Duchführung der Plasmapolymerisation bei einem Druck von weniger als 1 mbar, vorzugsweise im Bereich von 10⁻³ bis 10⁻¹ mbar
- Einstellung der Abscheiderate auf einen Wert von größer oder gleich 0,2 µm/min, vorzugsweise größer oder gleich 0,3 µm/min.

5. Verfahren nach einem der vorangehenden Ansprüche, wobei Schritt B bis zu einer Dicke der abgeschiedenen Schicht von größer oder gleich 2 µm, vorzugsweise größer oder gleich 4 µm durchgeführt wird.

6. Verfahren nach Anspruch 5, wobei in Schritt A die zu beschichtende Substratoberfläche mittels eines Plasmas gereinigt wird.

7. Verfahren nach einem der vorangehenden Ansprüche, wobei das Plasma mittels Hochfrequenz erzeugt wird.

8. Verfahren zur Herstellung eines Bauteiles, vorzugsweise eines Kunststoffformteils, mit einer Kratzschutzschicht, umfassend die Schritte:
a) Herstellen einer beschichteten Kunststofffolie mittels eines Verfahrens nach einem der vorangehenden Ansprüche,
b) Bereitstellen eines Trägermaterials und
c) Verbinden des Trägermaterials mit der beschichteten Kunststofffolie, so dass die Beschichtung der Kunststofffolie vom Trägermaterial weggerichtet ist.

9. Verfahren nach Anspruch 8, wobei der Schritt c) durch Laminieren, Kaschieren, Heißprägen, Spritzgießen, In-mould Labeling, Blasformen, Pressen, Hinterspritzen, Hinterprägen, Spritzprägen, Thermoformen, Strangablegen oder einer Kombination zweier oder mehrere dieser Verfahren erfolgt.

10. Verfahren nach Anspruch 8 oder 9, wobei eine dreidimensionale Verformung der beschichteten Kunststofffolie erfolgt.

11. Beschichtetes Kunststoffsubstrat, umfassend eine Kunststoffsubstratsubstrat und darauf angeordnet eine plasmapolymere Beschichtung, wobei die Beschichtung
- einen durch Messung mittels XPS bestimmbaren Anteil von Kohlenstoff von 3 bis 28 Atom %, vorzugsweise 5 bis 28 Atom-%, weiter vorzugsweise 7 bis 28 Atom-% Kohlenstoff aufweist, bezogen auf die Gesamtzahl der in der Beschichtung enthaltenen Kohlenstoff-, Silicium- und Sauerstoffatome.
- eine Rissdehnung von ≥ 2,5 %,
- einen nach ASTM D 1925 bestimmten Gelbindex (Yellow Index) von ≤ 3, vorzugsweise ≤ 2,5 und
- eine mittels Nanoindentation zu messende Härte im Bereich von 2,5 bis 6 GPa, vorzugsweise 3,1 bis 6 GPa
aufweist.

12. Beschichtetes Kunststoffsubstrat nach Anspruch 11, wobei ein von der Beschichtung aufgenommenes IR-Spektrum eine oder mehrere, vorzugsweise alle der folgenden Banden mit einem jeweiligen Maximum in den folgenden Bereichen aufweist: C-H-Valenzschwingung im Bereich von 2950 bis 2970 cm⁻¹, Si-H-Schwingung im Bereich von 2150 bis 2250 cm⁻¹, Si-CH₂-Si-Schwingung im Bereich von 1350 bis 1370 cm⁻¹, Si-CH₃-Deformationschwingung im Bereich von 1250 bis 1280 cm⁻¹ und Si-O-Schwingung bei größer oder gleich 1150 cm⁻¹, wobei vorzugsweise das Verhältnis der Intensität der Si-H-Bande zur Intensität der Si-CH₃-Bande kleiner oder gleich 0,3, vorzugsweise kleiner oder gleich 0,2 ist.

13. Beschichtetes Kunststoffsubstrat nach einem der Ansprüche 11 und 12, wobei die Beschichtung eines, mehrere oder alle Merkmale aufweist aus der Gruppe bestehend aus:
- eine Absorptionskonstante k_{300 nm} von kleiner oder gleich 0,05
- eine Absorptionskonstante k_{400 nm} von kleiner oder gleich 0,01
- eine Oberflächenenergie im Bereich von 20 bis 40 mN/m, vorzugsweise 25 bis 35 mN/m,
- durch Messung mittels XPS bestimmbarer Anteil von 5 bis 40 Atom-%, bevorzugt 20 bis 32 Atom-% Silicium bezogen auf die Gesamtzahl der in der Beschichtung enthaltenen Kohlenstoff-, Silicium- und Sauerstoffatome.
- durch Messung mittels XPS bestimmbarer Anteil von 30 bis 70 Atom-%, bevorzugt 40 bis 64 Atom-% Sauerstoff, bezogen auf die Gesamtzahl der in der Beschichtung enthaltenen Kohlenstoff-, Silicium- und Sauerstoffatome,
- eine maximale Schichtdicke, die sich von der minimalen Schichtdicke um den Faktor 1,1 oder geringer unterscheidet.

14. Bauteil, bevorzugt Kunststoffformteil, umfassend ein beschichtetes Kunststoffsubstrat nach einem der Ansprüche 11 bis 13 oder bestehend aus einem beschichtetem Kunststoffsubstrat nach einem der Ansprüche 11 bis 13.

15. Verwendung einer nach einem der Ansprüche 1 bis 7 herstellbaren beschichteten Kunststofffolie oder eines beschichteten Kunststoffsubstrates nach einem der Ansprüche 11 bis 13, das eine beschichtete Kunststofffolie ist, in Verfahren zum Laminieren, Kaschieren, Heißprägen, Spritzgießen, Blasformen, Pressen, Hinterspritzen, Hinterprägen, Spritzprägen, Strangablegen, bevorzugt als Laminier- oder Kaschierfolie und/oder als Folie für thermische Formgebungsverfahren und/oder als Folie zum Hinterspritzen.

## Claims

1. Process for coating the surface of a plastic substrate, with the following steps:
A. providing the plastic substrate and optionally cleaning the surface of the plastic substrate to be coated,
B. coating the substrate surface, optionally cleaned in step A, by plasma polymerisation in a high frequency plasma polymerisation reactor, wherein in step B
- as precursor(s) for the plasma one or more siliceous organic as well as (a) no further or (b) further compounds are applied and the plastic substrate is arranged in the high frequency plasma polymerisation reactor such that it is located between the zone, in which the plasma is formed, and the cathode,
an adjustment setting takes place, such that the self-bias is in the range of from 100 to 300 V,
**characterised in that** the process is performed such that the coating manufactured by the process has
- a fraction of carbon of from 3 to 28 atom-%, preferably 5 to 28 atom-%, more preferably 7 to 28 atom-%, referred to the total number of the carbon, silicium, and oxygen atoms contained in the coating, which can be determined by XPS measurement
- a fracture distension of ≥ 2.5 %
- a Yellow Index determined according to ASTM D 1925 of ≤ 3, preferably ≤ 2.5 and
- a hardness to be measured by nano-indentation in the range of from 2.5 to 6 GPa, preferably 3.1 to 6 GPa.

2. Process according to claim 1, wherein the plastic substrate has one or more or all features from the group consisting of:
- transparency or partial transparency in the range of visible light;
- the plastic substrate is a foil, preferably of a material selected from the group consisting of PVC, PE, PP, PC, PMMA, PET, POM and TPU;
- the plastic substrate is a thermoplastic or elastomer or a thermoplastic elastomer.

3. Process according to any one of the preceding claims, wherein in step B
- oxygen is supplied to the plasma and preferably all substances supplied to the plasma in step B are gaseous before entering into the high frequency plasma polymerisation reactor and the ratio of the gas flows supplied to the plasma in step B of oxygen and further precursor(s) are in range of from 1:1 to 6:1, preferably 3:1 to 5:1,
and/or
- as precursor(s) for the plasma one or more siloxanes, preferably hexamethyl disiloxane (HMDSO), optionally oxygen as well are applied as preferably further compounds.

4. Process according to any one of the preceding claims, wherein during step B one or more or all features are fulfilled from the group consisting of:
- adjustment of self-bias on the substrate, preferably by utilisation of an external direct current voltage source
- adjustment setting such that the total variation limit of the self-bias is at maximum 5%, prefrably at maximum 3% of the time-based average value
- contact of the plastic substrate with the cathode
- performing the plasma polymerisation at a temperature of less than 200°C
- performing the plasma polymerisation at a temperature of less than 1 mbar, preferably in the range of from 10⁻³ to 10⁻¹ mbar
- adjustment of the deposition ratio to a value of greater or equal to 0.2 µm/min, preferably greater or equal to 0.3 µm/min.

5. Process according to any one of the preceding claims, wherein step B is performed until a thickness of the deposited layer of greater or equal to 2 µm, preferably greater or equal to 4 µm.

6. Process according to claim 5, wherein in step A the surface of the substrate to be coated is cleaned by means of a plasma.

7. Process according to any one of the preceding claims, wherein the plasma is generated by means of high frequency.

8. Process for the manufacture of a component, preferably of a plastics moulding, with a protective layer against scratching, comprising the steps:
a) preparing a plastic foil by means of a process according to one of the preceding claims,
b) providing a carrier material and
c) joining the carrier material with the coated plastic foil such that the coating of the plastic foil is turned away from the carrier material.

9. Process according to claim 8, wherein step c) is effected by laminating, lining, hot stamping, injection moulding, in-mould labeling, blow forming, pressing, back injection moulding, back embossing , injection embossing, thermoforming, strand depositing or a combination of two or more of these processes.

10. Process according to any one of claims 8 or 9, wherein a three dimensional deformation of the coated plastic foil is effected.

11. Coated plastic substrate, comprising a plastic substrate and a plasma polymeric coating arranged thereupon, wherein the coating has
- a fraction of carbon of from 3 to 28 atom-%, preferably 5 to 28 atom-%, more preferably 7 to 28 atom-%, referred to the total number of the carbon, silicium, and oxygen atoms, which can be determined by XPS measurement
- a fracture distension of ≥ 2.5 %
- a Yellow Index determined according to ASTM D 1925 of ≤ 3, preferably ≤ 2.5 and
- a hardness to be measured by nano-indentation in the range of from 2.5 to 6 GPa, preferably 3.1 to 6 GPa.

12. Coated plastic substrate according to claim 11, wherein an IR spectrum recorded from the coating has one or more, preferably all of the following bands with a respective maximum in the following areas: C-H-valency vibration in the range of from 2950 to 2970 cm⁻¹, Si-H-vibration in the range of from 2150 to 2250 cm⁻¹, Si-CH₂-Si- vibration in the range of from 1350 to 1370 cm⁻¹, Si-CH₃-deformation vibration in the range of from 1250 to 1280 cm⁻¹ and Si-O-vibration of greater or equal to 1150 cm⁻¹, wherein preferably the ratio of the intensity of the Si-H-band to the intensity of the Si-CH₃-band is less than or equal to 0.3, preferably less than or equal to 0.2.

13. Coated plastic substrate according to any one of the claims 11 and 12, wherein the coating shows one or more or all features from the group consisting of:
- an absorption constant k_{300 nm} of less than or equal to 0.05
- an absorption constant k_{400 nm} of less than or equal to 0.01
- a surface energy in the range of from 20 to 40 mN/m, preferably 25 to 35 mN/m,
- a fraction of from 5 to 40 atom-%, preferably 20 to 32 atom-% silicium, referred to the total number of the carbon, silicium, and oxygen atoms contained in the coating, which can be determined by XPS measurement
- a fraction of from 30 to 70 atom-%, preferably 40 to 64 atom-% oxygen, referred to the total number of the carbon, silicium, and oxygen atoms contained in the coating, which can be determined by XPS measurement
- a maximum layer thickness, which differs from the minimal layer thickness by the factor 1.1 or less.

14. Component, preferably plastic moulding, comprising a coated plastic substrate according to any one of the claims 11 to 13 or consisting of a coated plastic substrate according to any one of the claims 11 to 13.

15. Use of coated plastic foil preparable according to any one of the claims 1 to 7 or a coated plastic substrate according to any one of the claims 11 to 13, that is a coated plastic foil, in a process for laminating, lining, hot stamping, injection moulding, blow forming, pressing, back injection moulding, back embossing, injection embossing, strand depositing, preferably as laminating or lining foil and/or as foil for thermal moulding processes and/or as foil for back injection moulding.

## Revendications

1. Procédé de revêtement de la surface d'un substrat synthétique, comprenant les étapes suivantes:
A. mise à disposition du substrat synthétique et éventuellement nettoyage de la surface de substrat à revêtir,
B. revêtement de la surface de substrat éventuellement nettoyée à l'étape A dans un réacteur de polymérisation par plasma à haute fréquence au moyen d'une polymérisation par plasma, dans lequel à l'étape B
- on utilise, comme précurseur(s) pour le plasma, un ou plusieurs composés organosiliciés (a) comme aucun autres ou (b) d'autres composés et
- le substrat synthétique est disposé dans un réacteur de polymérisation par plasma à haute fréquence de telle sorte qu'il se trouve entre la zone dans laquelle le plasma est formé et la cathode,
- une régulation s'effectue de sorte que l'auto-polarisation se situe dans la plage de 100 à 300 V, **caractérisé en ce que** le procédé est conduit de telle sorte que le revêtement produit par le procédé présente
- une proportion de carbone pouvant être déterminée par une mesure par XPS de 3 à 28 % d'atomes, de préférence de 5 à 28 % d'atomes, de manière davantage préférée de 7 à 28 % d'atome par rapport au nombre total d'atomes de carbone, de silicium et d'oxygène contenus dans le revêtement,
- un allongement à la rupture ≥ 2,5 %
- un indice de jaunissement (yellow index) déterminé selon la norme ASTM D 1925 ≤ 3, de préférence, ≤ 2,5 et
- une dureté à mesurer par nano-indentation dans la plage de 2,5 à 6 GPa, de préférence de 3,1 à 6 GPa.

2. Procédé selon la revendication 1, dans lequel le substrat synthétique présente une, plusieurs ou toutes les caractéristiques du groupe comprenant :
- une transparence ou une transparence partielle dans la plage de la lumière visible
- le substrat synthétique est un film, de préférence en un matériau choisi dans le groupe comprenant le PVC, le PE, le PP, le PC, le PMMA, le PET, le POM et le TPU ;
- le substrat synthétique est un thermoplastique ou un élastomère ou un élastomère thermoplastique.

3. Procédé selon l'une des revendications précédentes, dans lequel à l'étape B
- au plasma est acheminé de l'oxygène et de préférence toutes les substances acheminées au plasma à l'étape B sont sous forme gazeuse avant l'entrée dans le réacteur de polymérisation par plasma et le rapport des flux gazeux acheminés au plasma à l'étape B d'oxygène et autre(s) précurseur(s) se situe dans la plage de 1 _{:} 1 à 6 _{:} 1, de préférence 3 _{:} 1 à 5 _{:} 1
et/ou
- on utilise comme précurseur(s) pour le plasma un ou plusieurs siloxanes, de préférence l'hexaméthyldisiloxane (HMDSO), éventuellement de l'oxygène et de préférence pas d'autres composés.

4. Procédé selon l'une des revendications précédentes, dans lequel, pendant l'étape B, une, plusieurs ou toutes les caractéristiques sont remplies dans le groupe comprenant :
- un réglage de l'auto-polarisation sur le substrat, de préférence à l'aide d'une source de tension continue externe
- une régulation de telle sorte que l'amplitude de variation totale de l'auto-polarisation soit au maximum de 5 %, de préférence, au maximum de 3 % de la valeur moyenne temporelle,
- un contact du substrat synthétique avec la cathode,
- une réalisation de la polymérisation par plasma à une température inférieure à 200 °C,
- une réalisation de la polymérisation par plasma à une pression inférieure à 1 mbar, de préférence dans la plage de 10⁻³ à 10⁻¹ mbar,
- un réglage de la vitesse de dépôt à une valeur supérieure ou égale à 0,2 µm/min, de préférence supérieure ou égale à 0,3 µm/min.

5. Procédé selon l'une des revendications précédentes, dans lequel l'étape B est réalisée jusqu'à une épaisseur de la couche déposée supérieure ou égale à 2 µm, de préférence supérieure ou égale à 4 µm.

6. Procédé selon la revendication 5, dans lequel, à l'étape A, la surface de substrat à revêtir est nettoyée au moyen d'un plasma.

7. Procédé selon l'une des revendications précédentes, dans lequel le plasma est généré au moyen d'une haute fréquence.

8. Procédé de production d'un composant, de préférence d'une pièce moulée synthétique, comportant une couche de protection contre les rayures, comprenant les étapes de :
a) production d'un film synthétique revêtu au moyen d'un procédé selon l'une des revendications précédentes,
b) mise à disposition d'un matériau de support et
c) liaison du matériau de support avec la feuille synthétique revêtue de sorte que le revêtement de la feuille synthétique soit éloigné du matériau de support.

9. Procédé selon la revendication 8, dans lequel l'étape c) s'effectue par stratification, doublage, estampage à chaud, coulage par injection, étiquetage dans le moule, soufflage, pressage, injection arrière, estampage arrière, estampage par injection, thermoformage, dépôt en bande ou une combinaison de deux ou plusieurs de ces procédés.

10. Procédé selon la revendication 8 ou 9, dans lequel une déformation tridimensionnelle de la feuille synthétique revêtue est effectuée.

11. Substrat synthétique revêtu, comprenant un substrat de substrat synthétique et disposé sur celui-ci un revêtement de polymère par plasma, dans lequel le revêtement présente
- une proportion de carbone pouvant être déterminée par une mesure par XPS de 3 à 28 % d'atomes, de préférence de 5 à 28 % d'atomes, de manière davantage préférée de 7 à 28 % d'atome de carbone par rapport au nombre total d'atomes de carbone, de silicium et d'oxygène contenus dans le revêtement,
- un allongement à la rupture ≥ 2,5 %
- un indice de jaunissement (yellow index) déterminé selon la norme ASTM D 1925 ≤ 3, de préférence ≤ 2,5 et
- une dureté à mesurer par nano-indentation dans la plage de 2,5 à 6 GPa, de préférence de 3,1 à 6 GPa.

12. Substrat synthétique revêtu selon la revendication 11, dans lequel un spectre IR enregistré du revêtement présente une ou plusieurs, de préférence la totalité des bandes suivantes avec un maximum respectif dans les plages suivantes : variation de la valence C-H dans la plage de 2950 à 2970 cm⁻¹, variation de Si-H dans la plage de 2150 à 2250 cm⁻¹, variation de Si-CH₂-Si dans la plage de 1350 à 1370 cm⁻¹, variation de la déformation de Si-CH₃ dans la plage de 1250 à 1280 cm⁻¹ et variation de Si-O supérieure ou égale à 1150 cm⁻¹, dans lequel de préférence le rapport de l'intensité des bandes Si-H à l'intensité des bandes Si-CH₃ est inférieur ou égal à 0,3, de préférence inférieur ou égal à 0,2.

13. Substrat synthétique revêtu selon l'une des revendications 11 et 12, dans lequel le revêtement comprend une, plusieurs ou la totalité des caractéristiques du groupe comprenant :
- une constante d'absorption k₃₀₀ nm inférieure ou égale à 0,05
- une constante d'absorption k_{400 nm} inférieure ou égale à 0,01
- une énergie de surface dans la plage de 20 à 40 mN/m, de préférence de 25 à 35 mN/m,
- une proportion pouvant être déterminée par une mesure par XPS de 5 à 40 % d'atomes, de préférence 20 à 32 % d'atome de silicium par rapport au nombre total d'atomes de carbone, de silicium et d'oxygène contenus dans le revêtement,
- une proportion pouvant être déterminée par une mesure par XPS de 30 à 70 % d'atomes, de préférence 40 à 64 % d'atome d'oxygène par rapport au nombre total d'atomes de carbone, de silicium et d'oxygène contenus dans le revêtement,
- une épaisseur de couche maximale qui se distingue de l'épaisseur de couche minimale du facteur 1,1 ou inférieur.

14. Composant, de préférence pièce moulée synthétique, comprenant un substrat synthétique revêtu selon l'une des revendications 11 à 13 ou constitué d'un substrat synthétique revêtu selon l'une des revendications 11 à 13.

15. Utilisation d'un film synthétique revêtu, pouvant être produit selon l'une des revendications 1 à 7, ou d'un substrat synthétique revêtu selon l'une des revendications 11 à 13, qui est un film synthétique revêtu, dans un procédé de stratification, doublage, estampage à chaud, coulage par injection, soufflage, pressage, injection arrière, estampage arrière, estampage par injection, dépôt en bande, de préférence sous forme de film stratifié ou de film contrecollé et/ou sous forme de film pour le procédé de formage thermique et/ou de film pour l'injection arrière.
